# EUROPEAN PATENT APPLICATION

(11) **EP 4 394 873 A1**
(43) Date of publication of application: **03.07.2024**
(21) Application number: 23220026.1
(22) Date of filing: 22.12.2023
(51) Int. Cl.: H01L 25/075, H01L 25/16, H01L 33/00, H01L 33/40, H01L 33/44, H01L 33/54, H01L 33/62, H01L 33/20, H01L 33/38

(54) **LED BASED DISPLAY DEVICE AND METHOD OF MANUFACTURING THE SAME**

(30) Priority: 27.12.2022 KR 20220185728
(71) Applicant: LG Display Co., Ltd., Seoul 07336 (KR)
(72) Inventor: Lee, RokHee, 10845 Gyeonggi-do (KR); Son, HyeonHo, 10485 Gyeonggi-do (KR); Lee, DongSeok, 10845 Gyeonggi-do (KR); Rhim, JuSang, 10845 Gyeonggi-do (KR); Yoon, Sunghwan, 10845 Gyeonggi-do (KR); Kang, MinJae, 10845 Gyeonggi-do (KR); Shin, YuSeop, 10845 Gyeonggi-do (KR)
(74) Representative: Ter Meer Steinmeister & Partner

(57) **Abstract**

According to an aspect of the present disclosure, a display device (100) includes a substrate (110) in which a pixel (PX) including a plurality of sub pixels (SP1, SP2, SP3) is defined; an adhesive layer (116) disposed on the substrate; and a plurality of light emitting diodes (120, 130, 140) self-assembled which are transferred onto the adhesive layer and disposed in the plurality of sub pixels. Accordingly, each light emitting diode (120, 130, 140) is disposed on the adhesive layer (116) to fix the light emitting diode which is transferred from a donor (300). Also disclosed is a method of manufacturing said display device (100).

## Description

This application claims the priority of Republic of Korea Patent Application No. 10-2022-0185728 filed on December 27, 2022, in the Korean Intellectual Property Office.

### BACKGROUND

### Field

The present disclosure relates to a display device and a method of manufacturing the same, and more particularly, to a display device using a light emitting diode (LED) and a method of manufacturing the same.

### Description of the Related Art

As display devices which are used for a monitor of a computer, a television, or a cellular phone, there are an organic light emitting display device (OLED) which is a self-emitting device and a liquid crystal display device (LCD) which requires a separate light source.

An applicable range of the display device is diversified to personal digital assistants as well as monitors of computers and televisions and a display device with a large display area and a reduced volume and weight is being studied.

Further, recently, a display device including a light emitting diode (LED) is attracting attention as a next generation display device. Since the LED is formed of an inorganic material, rather than an organic material, reliability is excellent so that a lifespan thereof is longer than that of the liquid crystal display device or the organic light emitting display device. Further, the LED has a fast lighting speed, excellent luminous efficiency, and a strong impact resistance so that a stability is excellent and an image having a high luminance can be displayed.

### SUMMARY

An object to be achieved by the present disclosure is to provide a display device and a manufacturing method of a display device which reduces a transferring error of a light emitting diode.

Another object to be achieved by the present disclosure is to provide a display device and a manufacturing method of a display device which reduces the number of times of a transferring process of a light emitting diode to improve a production efficiency.

Still another object to be achieved by the present disclosure is to provide a display device and a manufacturing method of a display device which reduces a manufacturing cost.

Still another object to be achieved by the present disclosure is to provide a display device and a manufacturing method of a display device which minimizes the visible recognition of a wavelength deviation distribution of a light emitting diode.

Still another object to be achieved by the present disclosure is to provide a display device and a manufacturing method of a display device in which light emitting diodes are easily aligned.

Objects of the present disclosure are not limited to the above-mentioned objects, and other objects, which are not mentioned above, can be clearly understood by those skilled in the art from the following descriptions.

The object is solved by the features of the independent claims. Preferred embodiments are given in the dependent claims.

According to an aspect of the present disclosure, a display device includes a substrate in which a pixel including a plurality of sub pixels is defined; an adhesive layer disposed on the substrate; and a plurality of light emitting diodes self-assembled which are transferred onto the adhesive layer and disposed in the plurality of sub pixels. Accordingly, the light emitting diode is disposed on the adhesive layer to fix the light emitting diode which is transferred from the donor.

According to an aspect of the present disclosure, a display device includes: a thin film transistor over a substrate; a reflective electrode over the thin film transistor; a first planarization layer between the thin film transistor and the reflective electrode; a power line between the thin film transistor and the first planarization layer; an adhesive layer on the reflective electrode; a light-emitting diode on the adhesive layer and comprising a first electrode and a second electrode, the light-emitting diode being connected to the thin film transistor via the reflective electrode and a first connection electrode; an encapsulation layer over the light-emitting diode; a second planarization layer over the adhesive layer; and a third planarization layer over the encapsulation layer and the second planarization layer and a part of the third planarization layer being between the first electrode and the second electrode; wherein the second planarization layer and the third planarization layer surround the light-emitting diode and a thickness of the second planarization layer is different from that of the light-emitting diode.

According to an aspect of the present disclosure, a manufacturing method of a display device includes self-assembling a plurality of light emitting diodes on an assembling substrate; transferring the plurality of light emitting diodes which is self-assembled on the assembling substrate onto a donor; and transferring the plurality of light emitting diodes on the donor onto an adhesive layer of the display panel. The self-assembling of a plurality of light emitting diodes is a step of applying a voltage to a plurality of assembly electrodes to form an electric field and self-assembling a plurality of light emitting diodes on the plurality of assembly electrodes with the electric field. Accordingly, the light emitting diode may be self-assembled using the electric field to simplify the process of aligning the light emitting diode and reduce the alignment error.

According to an aspect of the present disclosure, a display device includes: a thin film transistor over a substrate; a reflective electrode over the thin film transistor; a first planarization layer between the thin film transistor and the reflective electrode; an adhesive layer on the reflective electrode; a light-emitting diode on the adhesive layer, wherein the light-emitting diode is connected to the thin film transistor via the reflective electrode and a connection electrode; a second planarization layer over the adhesive layer; a third planarization layer over the second planarization layer; and wherein the second planarization layer and the third planarization layer surround the light-emitting diode and an interface between the second planarization layer and the third planarization layer is in a different plane from a top surface of the light-emitting diode.

In the following optional features ore provided which can be combined with the above mentioned aspects alone or in combination or in sub-combination.

In one or more embodiments, the plurality of light emitting diodes may include a first light emitting diode, a second light emitting diode, and a third light emitting .

In one or more embodiments, self-assembling means the light emitting diodes are separately produced as one entity or as a single component.

In one or more embodiments, the self-assembling process means the light emitting diodes are connected or assembled on the substrate by applying an electrical field which helps to align the light emitting diodes into the structures on the substrate.

In one or more embodiments, the first light emitting diode, the second light emitting diode, and the third light emitting may have different planar shapes.

In one or more embodiments, the first light emitting diode may have a circular planar shape.

In one or more embodiments, the first light emitting diode may include a first n-type semiconductor layer in contact with an upper surface of the adhesive layer; a first light emitting layer on the first n-type semiconductor layer; a first p-type semiconductor layer on the first light emitting layer; a first n-type electrode along a periphery of an upper surface of the first n-type semiconductor layer; and a first p-type electrode on an upper surface of the first p-type semiconductor layer and having a circular planar shape.

In one or more embodiments, the second light emitting diode may have an elliptical planar shape.

In one or more embodiments, the second light emitting diode may include a second n-type semiconductor layer in contact with an upper surface of the adhesive layer and has an elliptical planar shape; a second light emitting layer on the second n-type semiconductor layer; a second p-type semiconductor layer on the second light emitting layer and has an elliptical planar shape; one pair of second n-type electrodes adjacent to both end portions of the second n-type semiconductor layer in a major axis direction of an upper surface of the second n-type semiconductor layer; and a second p-type electrode on an upper surface of the second p-type semiconductor layer and having an elliptical planar shape, and the major axis direction of the upper surface of the second n-type semiconductor layer and a major axis direction of the upper surface of the second p-type semiconductor layer are different.

In one or more embodiments, the third light emitting diode may have an elliptical planar shape having a different size from a planar shape of the second light emitting diode.

In one or more embodiments, the three different light emitting diodes have different forms of the first and/or second connecting electrodes.

The second connecting electrodes may have different forms, e.g. circular or elliptical.

The first connecting electrodes may have different forms, e.g. circular or two part electrode at the edge of the elliptical basic from of the light emitting diode.

In one or more embodiments, the third light emitting diode includes: a third n-type semiconductor layer in contact with the upper surface of the adhesive layer and has an elliptical planar shape; a third light emitting layer on the third n-type semiconductor layer; a third p-type semiconductor layer on the third light emitting layer and has an elliptical planar shape; one pair of third n-type electrodes adjacent to both end portions of the third n-type semiconductor layer in a major axis direction of an upper surface of the third n-type semiconductor layer; and a third p-type electrode on an upper surface of the third p-type semiconductor layer and having an elliptical planar shape, and the major axis direction of the upper surface of the third n-type semiconductor layer and a major axis direction of the upper surface of the third p-type semiconductor layer are a same.

In one or more embodiments, the plurality of light emitting diodes may be first self-assembled on an assembling substrate in an arrangement corresponding to the plurality of sub pixels and then transferred onto the adhesive layer.

In one or more embodiments, before being transferred onto the adhesive layer, the plurality of light emitting diodes that are self-assembled on the assembling substrate may be transferred onto a donor.

In one or more embodiments, the self-assembling of the plurality of light emitting diodes may be achieved by applying a voltage to a plurality of assembly electrodes on the assembling substrate to form an electric field and self-assembling the plurality of light emitting diodes on the plurality of assembly electrodes with the electric field.

In one or more embodiments, a step coverage may be between the adhesive layer and the second planarization layer.

In one or more embodiments, a step coverage may be between the second planarization layer and the third planarization layer.

In one or more embodiments, the display device may further comprise a light shielding layer on the substrate.

In one or more embodiments, the thin film transistor may comprise an active layer.

In one or more embodiments, the light shielding layer may overlap at least one of the light-emitting diode, the active layer, or the reflective electrode.

In one or more embodiments, the step coverage may be in a contact hole through the adhesive layer, the second planarization layer, and the third planarization layer.

In one or more embodiments, the second planarization layer and the third planarization layer surround the light-emitting diode and an interface between the second planarization layer and the third planarization layer is in a different plane from a top surface of the light-emitting diode.

In one or more embodiments, a signal may be supplied to the light-emitting diode via the first connection electrode and a second connection electrode.

In one or more embodiments, the self-assembling of the plurality of light emitting diodes may comprise applying a voltage to a plurality of assembly electrodes on the assembling substrate such that an electric field is formed and self-assembling the plurality of light emitting diodes on the plurality of assembly electrodes with the electric field.

In one or more embodiments, the assembling substrate may further include an assembly substrate; a plurality of first assembly lines on the assembly substrate; a plurality of second assembly lines on the assembly substrate and are alternately disposed with the plurality of first assembly lines; an organic layer on the plurality of first assembly lines and the plurality of second assembly lines and includes a plurality of openings; and an assembly insulating layer on the organic layer, and the plurality of assembly electrodes includes: a plurality of first assembly electrodes that are electrically connected to the plurality of first assembly lines; and a plurality of second assembly electrodes that are electrically connected to the plurality of second assembly lines and face the plurality of first assembly electrodes with a predetermined interval.

In one or more embodiments, each of the plurality of first assembly lines may include a first line part extending in a first direction on the assembly substrate; and a first protrusion part which includes a first part extending from one side surface of the first line part along a second direction and a second part which is connected to an end portion of the first part and extends in the first direction.

In one or more embodiments, each of the plurality of second assembly lines may include a second line part extending in the first direction on the assembly substrate; and a second protrusion part which includes a third part extending from another side surface of the second line part to the second direction and a fourth part which is connected to an end portion of the third part and extends in the first direction.

In one or more embodiments, the first protrusion part and the second protrusion part may be alternately disposed.

In one or more embodiments, the plurality of first assembly electrodes may be disposed to protrude along the second direction from one side surface of the first line part and both side surfaces of the second part.

In one or more embodiments, the plurality of second assembly electrodes may be disposed to protrude along the second direction from another side surface of the second line part and both side surfaces of the fourth part.

In one or more embodiments, the plurality of light emitting diodes may include a plurality of first light emitting diodes having a circular planar shape; a plurality of second light emitting diodes having an elliptical planar shape; and a plurality of third light emitting diodes having an elliptical planar shape having a major axis longer than that of the elliptical planar shape of the plurality of second light emitting diodes.

In one or more embodiments, the plurality of openings of the organic layer may include a plurality of first openings having a planar shape corresponding to the plurality of first light emitting diodes; a plurality of second openings having a planar shape corresponding to the plurality of second light emitting diodes; and a plurality of third openings having a planar shape corresponding to the plurality of third light emitting diodes.

In one or more embodiments, the self-assembling of the plurality of light emitting diodes on the assembling substrate may include self-assembling the plurality of first light emitting diodes in the plurality of first openings, self-assembling the plurality of second light emitting diodes in the plurality of second openings, and self-assembling the plurality of third light emitting diodes in the plurality of third openings; and self-assembling a plurality of alignment keys in any one of the plurality of first openings.

In one or more embodiments, the assembling substrate may further include a first alignment pattern between the assembly substrate and the assembly insulating layer, and the transferring of the plurality of light emitting diodes which are self-assembled on the assembling substrate onto a donor may include aligning the assembling substrate and the donor by aligning the first alignment pattern of the assembling substrate and a second alignment pattern of the donor; and transferring the plurality of light emitting diodes and the plurality of alignment keys on the assembling substrate onto the donor.

In one or more embodiments, the donor may further include a base substrate; a resin layer on the base substrate; a plurality of chip protrusions on the resin layer a plurality of dummy protrusions on the resin layer; and a plurality of alignment protrusions on the resin layer.

In one or more embodiments, the second alignment pattern may be disposed on the resin layer.

In one or more embodiments, the transferring of the plurality of light emitting diodes and the plurality of alignment keys on the assembling substrate onto the donor may include transferring the plurality of light emitting diodes onto the plurality of chip protrusions and transferring the plurality of alignment keys onto the plurality of alignment protrusions.

In one or more embodiments, the plurality of light emitting diodes may be disposed on one chip protrusion among the plurality of chip protrusions.

In one or more embodiments, the display panel may further include a substrate which supports the adhesive layer; and a plurality of third alignment patterns disposed on the substrate, and the transferring of the plurality of light emitting diodes on the donor onto the adhesive layer of the display panel may include aligning the donor and the display panel by aligning the plurality of alignment keys on the plurality of alignment protrusions of the donor and the plurality of third alignment patterns; and transferring the plurality of light emitting diodes and the plurality of alignment keys on the donor onto the adhesive layer.

Other detailed matters of the exemplary embodiments are included in the detailed description and the drawings.

According to the present disclosure, an alignment error of the light emitting diode during the transferring process may be reduced.

According to the present disclosure, a donor size is expandable so that the number of times of a transferring process of a light emitting diode may be reduced and a production efficiency may be improved.

According to the present disclosure, the transferring process may be simplified to reduce the manufacturing cost.

According to the present disclosure, the visible recognition of the wavelength deviation distribution on the wafer from a display panel may be minimized.

According to the present disclosure, during the self-assembling, a plurality of light emitting diodes is uniformly mixed to be self-assembled, thereby minimizing the visible recognition of color and luminance irregularity between a plurality of areas of a display panel in which light emitting diodes are transferred from different donors.

The effects according to the present disclosure are not limited to the contents exemplified above, and more various effects are included in the present specification.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a schematic diagram of a display device according to an exemplary embodiment of the present disclosure;
FIG. 2A is a partial cross-sectional view of a display device according to an exemplary embodiment of the present disclosure;
FIG. 2B is a perspective view of a tiling display device according to an exemplary embodiment of the present disclosure;
FIG. 3 is an enlarged plan view of a display device according to an exemplary embodiment of the present disclosure;
FIG. 4 is a cross-sectional view of a display device according to an exemplary embodiment of the present disclosure;
FIGS. 5A to 5C are views for explaining a plurality of light emitting diodes of a display device according to an exemplary embodiment of the present disclosure;
FIG. 6 is a plan view of an assembling substrate according to an exemplary embodiment of the present disclosure;
FIG. 7A is an enlarged plan view of an assembly area of an assembling substrate of a display device according to an exemplary embodiment of the present disclosure;
FIG. 7B is a cross-sectional view taken along VIIb-VIIb' of FIG. 7A according to an exemplary embodiment of the present disclosure;
FIG. 8 is an enlarged plan view of a first alignment area of an assembling substrate of a display device according to an exemplary embodiment of the present disclosure;
FIG. 9 is a plan view of a donor of an exemplary embodiment of the present disclosure;
FIGS. 10A and 10B are cross-sectional views taken along the line X-X' of FIG. 9 according to an exemplary embodiment of the present disclosure;
FIG. 11A is an enlarged plan view of a displacement measuring area of a donor according to an exemplary embodiment of the present disclosure;
FIG. 11B is an enlarged plan view of a second alignment area of a donor according to an exemplary embodiment of the present disclosure;
FIGS. 12A to 12H are process diagrams for explaining a method of manufacturing a display device according to an exemplary embodiment of the present disclosure;
FIG. 13A is a view illustrating a screen of a display device of a comparative embodiment;
FIG. 13B is a graph illustrating a wavelength distribution measured along the line A-A' of FIG. 13A;
FIG. 14A is a view illustrating a screen of a display device according to an exemplary embodiment of the present disclosure; and
FIG. 14B is a graph illustrating a wavelength distribution measured along the line B-B' of FIG. 14A according to an exemplary embodiment of the present disclosure.

### DETAILED DESCRIPTION

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure.

The shapes, sizes, ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "comprising" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, another layer or another element may be interposed directly on the other element or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, a display device and a manufacturing method of the display device according to exemplary embodiments of the present disclosure will be described in detail with reference to accompanying drawings.

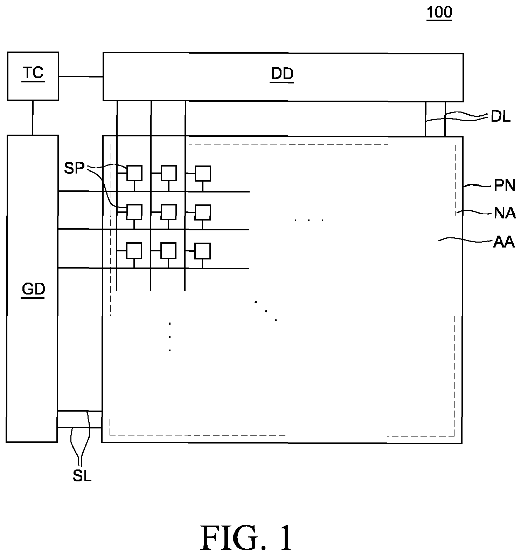

FIG. 1 is a schematic diagram of a display device according to an exemplary embodiment of the present disclosure. In FIG. 1, for the convenience of description, among various components of the display device 100, a display panel PN, a gate driver GD, a data driver DD, and a timing controller TC are illustrated.

Referring to FIG. 1, the display device 100 includes a display panel PN including a plurality of sub pixels SP, a gate driver GD and a data driver DD which supply various signals to the display panel PN, and a timing controller TC which controls the gate driver GD and the data driver DD.

The gate driver GD supplies a plurality of scan signals to a plurality of scan lines SL in accordance with a plurality of gate control signals supplied from the timing controller TC. Even though in FIG. 1, it is illustrated that one gate driver GD is disposed to be spaced apart from one side of the display panel PN, the number of the gate drivers GD and the placement thereof are not limited thereto.

The data driver DD converts image data input from the timing controller TC into a data voltage using a reference gamma voltage in accordance with a plurality of data control signals supplied from the timing controller TC. The data driver DD may supply the converted data voltage to the plurality of data lines DL.

The timing controller TC aligns image data input from the outside to supply the image data to the data driver DD. The timing controller TC may generate a gate control signal and a data control signal using synchronization signals input from the outside, such as a dot clock signal, a data enable signal, and horizontal/vertical synchronization signals. The timing controller TC supplies the generated gate control signal and data control signal to the gate driver GD and the data driver DD, respectively, to control the gate driver GD and the data driver DD.

The display panel PN is a configuration which displays images to the user and includes the plurality of sub pixels SP. In the display panel PN, the plurality of scan lines SL and the plurality of data lines DL intersect each other and the plurality of sub pixels SP is connected to the scan lines SL and the data lines DL, respectively. In addition, even though it is not illustrated in the drawing, each of the plurality of sub pixels SP is connected to a high potential power line, a low potential power line, a reference line, and the like.

In the display panel PN, an active area AA and the non-active area NA enclosing the active area AA may be defined.

The active area AA is an area in which images are displayed in the display device 100. In the active area AA, a plurality of sub pixels SP which configures a plurality of pixels PX and a circuit for driving the plurality of sub pixels SP may be disposed. The plurality of sub pixels SP is a minimum unit which configures the active area AA and n sub pixels SP form one pixel PX. In each of the plurality of sub pixels SP, a light emitting diode, thin film transistor for driving the light emitting diode, and the like may be disposed. The plurality of light emitting diodes may be defined in different manners depending on the type of the display panel PN. For example, when the display panel PN is an inorganic light emitting display panel, the light emitting diode may be a micro light emitting diode (LED).

In the active area AA, a plurality of signal lines which transmits various signals to the plurality of sub pixels SP is disposed. For example, the plurality of signal lines may include a plurality of data lines DL which supplies a data voltage to each of the plurality of sub pixels SP, a plurality of scan lines SL which supplies a gate voltage to each of the plurality of sub pixels SP, and the like. The plurality of scan lines SL extends in one direction in the active area AA to be connected to the plurality of sub pixels SP and the plurality of data lines DL extends in a direction different from the one direction in the active area AA to be connected to the plurality of sub pixels SP. In addition, in the active area AA, a low potential power line, a high potential power line, and the like may be further disposed, but are not limited thereto.

The non-active area NA is an area where images are not displayed so that the non-active area NA may be defined as an area extending from the active area AA. In the non-active area NA, a link line which transmits a signal to the sub pixel SP of the active area AA, a pad electrode, or a driving IC, such as a gate driver IC or a data driver IC, etc., may be disposed. The non-active area NA may be located on a rear surface of the display panel PN, that is, a surface on which the sub pixels SP are not disposed or may be omitted, and is not limited as illustrated in the drawing.

In the meantime, a driver, such as a gate driver GD, a data driver DD, and a timing controller TC, may be connected to the display panel PN in various ways. For example, the gate driver GD may be mounted in the non-active area NA in a gate in panel (GIP) manner or mounted between the plurality of sub pixels SP in the active area AA in a gate in active area (GIA) manner. For example, the data driver DD and the timing controller TC are formed in separate flexible film and printed circuit board and are electrically connected to the display panel PN by bonding the flexible film and the printed circuit board to a pad electrode formed in the non-active area NA of the display panel PN. If the gate driver GD is mounted in the GIP manner and the data driver DD and the timing controller TC transmit a signal to the display panel PN through a pad electrode of the non-active area NA, an area of the non-active area NA to dispose the gate driver GD and the pad electrode needs to be ensured. By doing this, a bezel may be increased.

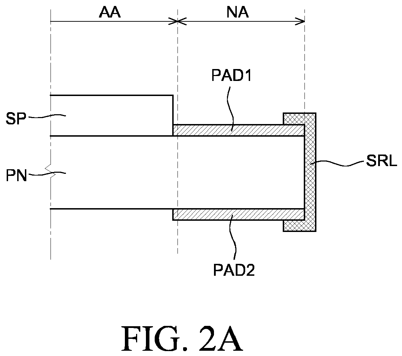

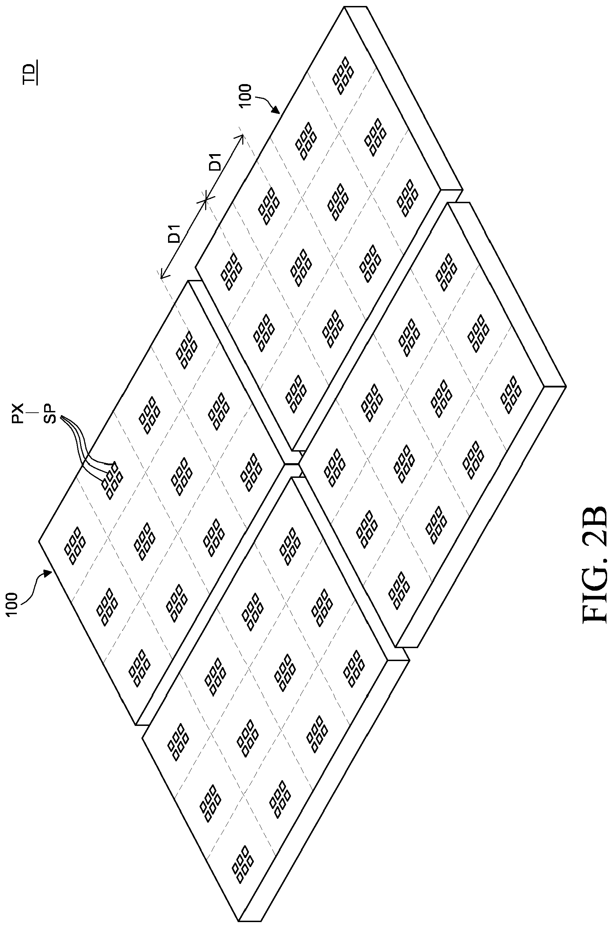

In contrast, when the gate driver GD is mounted in the active area AA in the GIA manner and a side line SRL which connects the signal line on the front surface of the display panel PN to the pad electrode on a rear surface of the display panel PN is formed to bond the flexible film and the printed circuit board onto a rear surface of the display panel PN, the non-active area NA may be minimized on the front surface of the display panel PN. That is, when the gate driver GD, the data driver DD, and the timing controller TC are connected to the display panel PN as described above, a zero bezel in which there is no bezel may be substantially implemented, which will be described in more detail with reference to FIGS. 2A and 2B.

FIG. 2A is a partial cross-sectional view of a display device according to an exemplary embodiment of the present disclosure. FIG. 2B is a perspective view of a tiling display device according to an exemplary embodiment of the present disclosure.

In the non-active area NA of the display panel PN, a plurality of pad electrodes for transmitting various signals to the plurality of sub pixels SP are disposed. For example, in the non-active area NA of the front surface of the display panel PN, a first pad electrode PAD1 which transmits a signal to the plurality of sub pixels SP is disposed. In the non-active area NA of the rear surface of the display panel PN, a second pad electrode PAD2 which is electrically connected to a driving component, such as a flexible film and the printed circuit board, is disposed.

In this case, even though it is not illustrated in the drawing, various signal lines connected to the plurality of sub pixels SP, for example, a scan line SL or a data line DL extends from the active area AA to the non-active area NA to be electrically connected to the first pad electrode PAD 1.

The side line SRL is disposed along a side surface of the display panel PN. The side line SRL may electrically connect a first pad electrode PAD 1 on the front surface of the display panel PN and a second pad electrode PAD2 on the rear surface of the display panel PN. Therefore, a signal from a driving component on the rear surface of the display panel PN is transmitted to the plurality of sub pixels SP through the second pad electrode PAD2, the side line SRL, and the first pad electrode PAD1. Accordingly, a signal transmitting path from the front surface of the display panel PN to the side surface and the rear surface is formed to minimize or reduce an area of the non-active area NA of the display panel PN.

Referring to FIG. 2B, a tiling display device TD having a large screen size may be implemented by connecting a plurality of display devices 100. At this time, as illustrated in FIG. 2A, when the tiling display device TD is implemented using a display device 100 with a reduced bezel, a seam area between the display devices 100 in which an image is not displayed is reduced so that a display quality may be improved.

For example, the plurality of sub pixels SP forms one pixel PX and a distance D1 between an outermost pixel PX of one display device 100 and an outermost pixel PX of another display device 100 adjacent to one display device may be implemented to be equal to a distance D1 between pixels PX in one display device 100. Accordingly, the distance between pixels PX between the display devices 100 is constantly configured to reduce the seam area.

However, FIGS. 2A and 2B are illustrative so that the display device 100 according to the exemplary embodiment of the present disclosure may be a general display device with a bezel, but is not limited thereto.

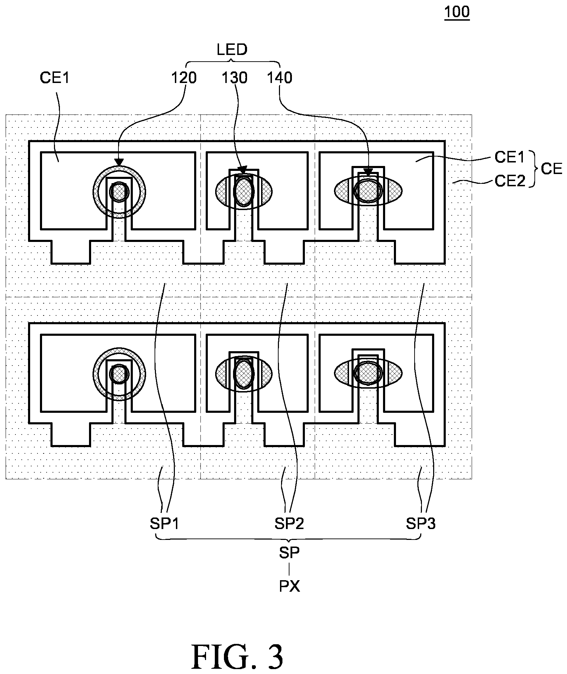

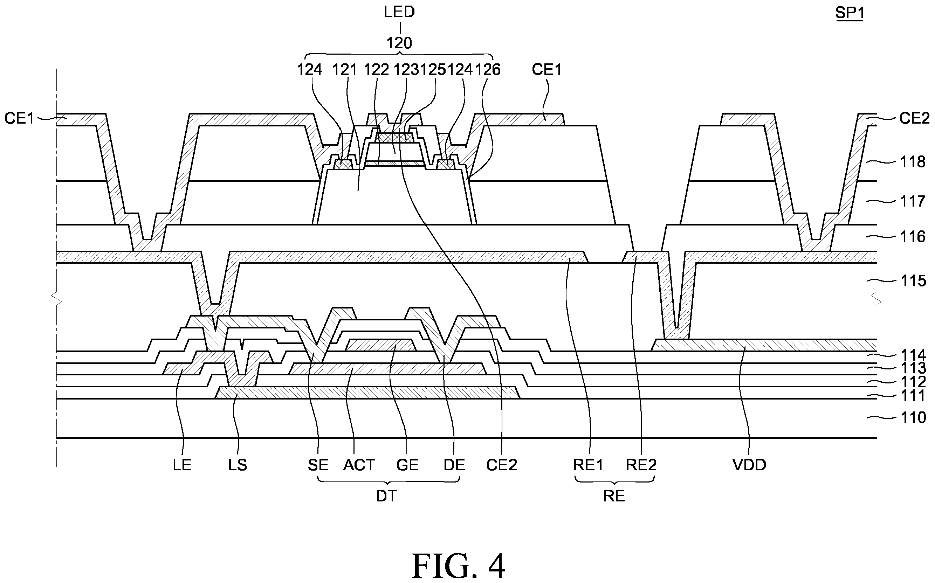

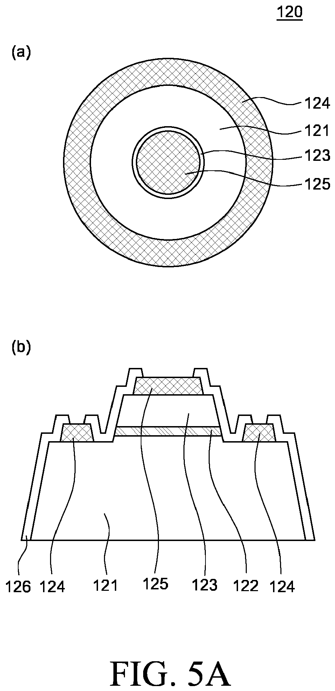

FIG. 3 is an enlarged plan view of a display device according to an exemplary embodiment of the present disclosure. FIG. 4 is a cross-sectional view of a display device according to an exemplary embodiment of the present disclosure. FIGS. 5A to 5C are views for explaining a plurality of light emitting diodes of a display device according to an exemplary embodiment of the present disclosure.

First, referring to FIG. 3, the display panel PN includes a plurality of pixels PX which are formed by a plurality of sub pixels SP. Each of the plurality of sub pixels SP includes a light emitting diode LED and a pixel circuit to independently emit light. One pixel PX includes one or more first sub pixels SP1, one or more second sub pixels SP2, and one or more third sub pixels SP3. For example, one pixel PX includes two first sub pixels SP1, two second sub pixels SP2, and two third sub pixels SP3. At this time, the first sub pixel SP1 is a red sub pixel, the second sub pixel SP2 is a green sub pixel, and the third sub pixel SP3 is a blue sub pixel, but they are not limited thereto.

Next, referring to FIG. 4 together, in each of the plurality of sub pixels SP of the display panel PN of the display device 100 according to the exemplary embodiment of the present disclosure, a substrate 110, a buffer layer 111, a gate insulating layer 112, a first interlayer insulating layer 113, a second interlayer insulating layer 114, a first planarization layer 115, an adhesive layer 116, a second planarization layer 117, a third planarization layer 118, a driving transistor DT, a light emitting diode LED, a plurality of reflective electrodes RE, a plurality of connection electrodes CE, a light shielding layer LS, and an auxiliary electrode LE are disposed.

First, the substrate 110 is a component for supporting various components included in the display device 100 and may be formed of an insulating material. For example, the substrate 110 may be formed of glass, resin, or the like. Further, the substrate 110 may be configured to include polymer or plastics or may be formed of a material having flexibility.

The light shielding layer LS is disposed in each of the plurality of sub pixels SP on the substrate 110. The light shielding layer LS blocks light incident onto an active layer ACT of the driving transistor DT to be described below, below the substrate 110. Light which is incident onto the active layer ACT of the driving transistor DT is blocked by the light shielding layer LS to reduce a leakage current.

The buffer layer 111 is disposed on the substrate 110 and the light shielding layer LS. The buffer layer 111 may reduce permeation of moisture or impurities through the substrate 110. The buffer layer 111 may be configured by a single layer or a double layer of silicon oxide SiOx or silicon nitride SiNx, but is not limited thereto. However, the buffer layer 111 may be omitted depending on a type of substrate 110 or a type of transistor, but is not limited thereto.

The driving transistor DT is disposed on the buffer layer 111. The driving transistor DT includes an active layer ACT, a gate electrode GE, a source electrode SE, and a drain electrode DE.

The active layer ACT is disposed on the buffer layer 111. The active layer ACT may be formed of a semiconductor material, such as an oxide semiconductor, amorphous silicon, or polysilicon, but is not limited thereto.

The gate insulating layer 112 is disposed on the active layer ACT. The gate insulating layer 112 is an insulating layer which insulates the active layer ACT from the gate electrode GE and may be configured by a single layer or a double layer of silicon oxide (SiOx) or silicon nitride (SiNx), but is not limited thereto.

The gate electrode GE is disposed on the gate insulating layer 112. The gate electrode GE may be configured by a conductive material, such as copper (Cu), aluminum (Al), molybdenum (Mo), nickel (Ni), titanium (Ti), chrome (Cr), or an alloy thereof, but is not limited thereto.

The first interlayer insulating layer 113 and the second interlayer insulating layer 114 are disposed on the gate electrode GE. In the first interlayer insulating layer 113 and the second interlayer insulating layer 114, a contact hole through which the source electrode SE and the drain electrode DE are connected to the active layer ACT, respectively, is formed. The first interlayer insulating layer 113 and the second interlayer insulating layer 114 are insulating layers for protecting a component below the first interlayer insulating layer 113 and the second interlayer insulating layer 114 and may be configured by a single layer or a double layer of silicon oxide SiOx or silicon nitride SiNx, but are not limited thereto.

The source electrode SE and the drain electrode DE which are electrically connected to the active layer ACT are disposed on the second interlayer insulating layer 114. The source electrode SE and the drain electrode DE may be configured by a conductive material, such as copper (Cu), aluminum (Al), molybdenum (Mo), nickel (Ni), titanium (Ti), chrome (Cr), or an alloy thereof, but are not limited thereto.

In the meantime, in the present specification, it is described that the first interlayer insulating layer 113 and the second interlayer insulating layer 114, that is, a plurality of insulating layers is disposed between the gate electrode GE and the source electrode SE and the drain electrode DE. However, one insulating layer may be disposed between the gate electrode GE and the source electrode SE and the drain electrode DE.

As illustrated in the drawings, when a plurality of insulating layers, such as the first interlayer insulating layer 113 and the second interlayer insulating layer 114, is disposed between the gate electrode GE and the source electrode SE and the drain electrode DE, an electrode may be further formed between the first interlayer insulating layer 113 and the second interlayer insulating layer 114. The additionally formed electrode may form a capacitor with the other configuration disposed below the first interlayer insulating layer 113 or above the second interlayer insulating layer 114.

The auxiliary electrode LE is disposed on the gate insulating layer 112. The auxiliary electrode LE is an electrode which electrically connects the light shielding layer LS below the buffer layer 111 to any one of the source electrode SE and the drain electrode DE on the second interlayer insulating layer 114. For example, the light shielding layer LS is electrically connected to any one of the source electrode SE or the drain electrode DE through the auxiliary electrode LE so as not to operate as a floating gate. Therefore, fluctuation of a threshold voltage of the driving transistor DT caused by the floated light shielding layer LS may be reduced. Even though in the drawing, the light shielding layer LS is connected to the source electrode SE, the light shielding layer LS may also be connected to the drain electrode DE, but is not limited thereto.

The power line VDD is disposed on the second interlayer insulating layer 114. The power line VDD is electrically connected to the light emitting diode LED together with the driving transistor DT to allow the light emitting diode LED to emit light. The power line VDD may be configured by a conductive material such as copper (Cu), aluminum (Al), molybdenum (Mo), nickel (Ni), titanium (Ti), chrome (Cr), or an alloy thereof, but is not limited thereto.

The first planarization layer 115 is disposed on the driving transistor DT and the power line VDD. The first planarization layer 115 may planarize an upper portion of the substrate 110 on which the driving transistor DT is disposed. The first planarization layer 115 may be configured by a single layer or a double layer, and for example, may be formed of photo resist or an acrylic organic material, but is not limited thereto.

A plurality of reflective electrodes RE which are spaced apart from each other are disposed on the first planarization layer 115. The plurality of reflective electrodes RE electrically connects the light emitting diode LED to the power line VDD and the driving transistor DT and may serve as a reflector which reflects light emitted from the light emitting diode LED to the upper portion of the light emitting diode LED. The plurality of reflective electrodes RE are formed of a conductive material having the excellent reflecting property to reflect light emitted from the light emitting diode LED toward the upper portion of the light emitting diode LED. The light shielding layer LS may overlap with at least one of the light-emitting diode, the active layer of the driving transistor DT, and the reflective electrode RE.

The plurality of reflective electrodes RE includes a first reflective electrode RE1 and a second reflective electrode RE2. The first reflective electrode RE1 may electrically connect the driving transistor DT and the light emitting diode LED. The first reflective electrode RE1 may be connected to the source electrode SE or the drain electrode DE of the driving transistor DT through a contact hole formed in the first planarization layer 115. The first reflective electrode RE1 may be electrically connected to the first electrode and the first semiconductor layer of the light emitting diode LED through a first connection electrode CE1 to be described below.

The second reflective electrode RE2 may electrically connect the power line VDD and the light emitting diode LED. The second reflective electrode RE2 is connected to the power line VDD through a contact hole formed in the first planarization layer 115 and may be electrically connected to p-type electrodes 125, 135, and 145 and p-type semiconductor layers 123, 133, and 143 of the light emitting diode LED through a second connection electrode CE2 to be described below.

The adhesive layer 116 is disposed on the plurality of reflective electrodes RE. The adhesive layer 116 is coated on the front surface of the substrate 110 to fix the light emitting diode LED disposed on the adhesive layer 116. For example, the adhesive layer 116 may be selected from any one of adhesive polymer, epoxy resist, UV resin, polyimide, acrylate, urethane, and polydimethylsiloxane (PDMS), but is not limited thereto.

The plurality of light emitting diodes LED are disposed in each of the plurality of sub pixels SP on the adhesive layer 116. The plurality of light emitting diodes LED are elements which emit light by a current and may include a light emitting diode LED which emits red light, green light, and blue light and implement various colored light including white by a combination thereof. For example, the plurality of light emitting diodes LED may be a micro LED, but is not limited thereto.

Referring to FIGS. 5A to 5C together, the plurality of light emitting diodes LED includes a first light emitting diode 120, a second light emitting diode 130, and a third light emitting diode 140. The first light emitting diode 120 may be disposed in the first sub pixel SP1, the second light emitting diode 130 may be disposed in the second sub pixel SP2, and the third light emitting diode 140 may be disposed in the third sub pixel SP3. For example, the first light emitting diode 120 may be a red light emitting diode, the second light emitting diode 130 may be a green light emitting diode, and the third light emitting diode 140 may be a blue light emitting diode.

Referring to FIGS. 4 and 5A together, the first light emitting diode 120 includes a first n-type semiconductor layer 121, a first light emitting layer 122, a first p-type semiconductor layer 123, a first n-type electrode 124 and a first p-type electrode 125. A first encapsulation layer 126 may be disposed over the first light emitting diode 120.

The first n-type semiconductor layer 121 is disposed on the adhesive layer 116 and the first p-type semiconductor layer 123 is disposed on the first n-type semiconductor layer 121. The first n-type semiconductor layer 121 and the first p-type semiconductor layer 123 may be formed by doping n-type and p-type impurities into a specific material. For example, the first n-type semiconductor layer 121 and the first p-type semiconductor layer 123 may be layers formed by doping n-type and p-type impurities into a material such as gallium nitride (GaN), indium aluminum phosphide (InAlP), or gallium arsenide (GaAs). The p-type impurity may be magnesium (Mg), zinc (Zn), beryllium (Be), and the like, and the n-type impurity may be silicon (Si), germanium, tin (Sn), and the like, but are not limited thereto.

The first light emitting layer 122 is disposed between the first n-type semiconductor layer 121 and the first p-type semiconductor layer 123. The first light emitting layer 122 is supplied with holes and electrons from the first n-type semiconductor layer 121 and the first p-type semiconductor layer 123 to emit light. The first light emitting layer 122 may be formed by a single layer or a multi-quantum well (MQW) structure, and for example, may be formed of indium gallium nitride (InGaN), gallium nitride (GaN), or the like, but is not limited thereto.

The first n-type electrode 124 is disposed on the first n-type semiconductor layer 121. The first n-type electrode 124 is an electrode which electrically connects the driving transistor DT and the first n-type semiconductor layer 121. The first n-type electrode 124 may be disposed on an upper surface of the first n-type semiconductor layer 121 which is exposed from the first light emitting layer 122 and the first p-type semiconductor layer 123. For example, the first n-type electrode 124 is disposed along a periphery of an upper surface of the first n-type semiconductor layer 121 and may have a ring shape in plan view. The first n-type electrode 124 may be configured by a conductive material, for example, a transparent conductive material, such as indium tin oxide (ITO) or indium zinc oxide (IZO) or an opaque conductive material, such as titanium (Ti), gold (Au), silver (Ag), copper (Cu) or an alloy thereof, but is not limited thereto.

The first p-type electrode 125 is disposed on the first p-type semiconductor layer 123. The first p-type electrode 125 may be disposed on the upper surface of the first p-type semiconductor layer 123. The first p-type electrode 125 is an electrode which electrically connects the power line VDD and the first p-type semiconductor layer 123. The first p-type electrode 125 may be configured by a conductive material, for example, a transparent conductive material, such as indium tin oxide (ITO) or indium zinc oxide (IZO) or an opaque conductive material, such as titanium (Ti), gold (Au), silver (Ag), copper (Cu), or an alloy thereof, but is not limited thereto.

Next, the first encapsulation layer 126 which encloses the first n-type semiconductor layer 121, the first light emitting layer 122, the first p-type semiconductor layer 123, the first n-type electrode 124, and the first p-type electrode 125 is disposed. The first encapsulation layer 126 is formed of an insulating material to protect the first n-type semiconductor layer 121, the first light emitting layer 122, and the first p-type semiconductor layer 123. In the first encapsulation layer 126, a contact hole which exposes the first n-type electrode 124 and the first p-type electrode 125 is formed to electrically connect the first connection electrode CE1 and the second connection electrode CE2 to the first n-type electrode 124 and the first p-type electrode 125.

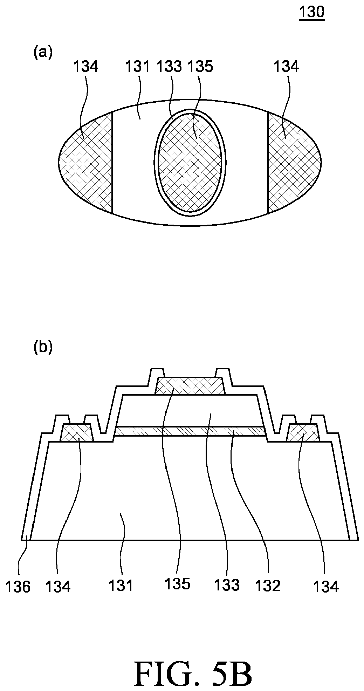

Referring to FIG. 5B, the second light emitting diode 130 includes a second n-type semiconductor layer 131, a second light emitting layer 132, a second p-type semiconductor layer 133, a second n-type electrode 134 and a second p-type electrode 135. A second encapsulation layer 136 may be disposed over the second light emitting diode 130.

The second n-type semiconductor layer 131 is disposed on the adhesive layer 116 and the second p-type semiconductor layer 133 is disposed on the second n-type semiconductor layer 131. The second n-type semiconductor layer 131 and the second p-type semiconductor layer 133 may be formed by doping n-type and p-type impurities into a specific material. For example, the second n-type semiconductor layer 131 and the second p-type semiconductor layer 133 may be layers formed by doping n-type and p-type impurities into a material such as gallium nitride (GaN), indium aluminum phosphide (InAlP), or gallium arsenide (GaAs). The p-type impurity may be magnesium (Mg), zinc (Zn), beryllium (Be), and the like, and the n-type impurity may be silicon (Si), germanium, tin (Sn), and the like, but are not limited thereto.

The second light emitting layer 132 is disposed between the second n-type semiconductor layer 131 and the second p-type semiconductor layer 133. The second light emitting layer 132 is supplied with holes and electrons from the second n-type semiconductor layer 131 and the second p-type semiconductor layer 133 to emit light. The second light emitting layer 132 may be formed by a single layer or a multi-quantum well (MQW) structure, and for example, may be formed of indium gallium nitride (InGaN), gallium nitride (GaN), or the like, but is not limited thereto.

One or more second n-type electrodes 134 are disposed on the second n-type semiconductor layer 131. The second n-type electrode 134 is an electrode which electrically connects the driving transistor DT and the second n-type semiconductor layer 131. The second n-type electrode 134 may be disposed on an upper surface of the second n-type semiconductor layer 131 which is exposed from the second light emitting layer 132 and the second p-type semiconductor layer 133. For example, the second n-type electrode 134 may be disposed to be adjacent to both end portions of the upper surface of the second n-type semiconductor layer 131 in a major axis direction, on the upper surface of the second n-type semiconductor layer 131 formed with an elliptical planar shape. The second n-type electrode 134 may be configured by a conductive material, for example, a transparent conductive material, such as indium tin oxide (ITO) or indium zinc oxide (IZO) or an opaque conductive material, such as titanium (Ti), gold (Au), silver (Ag), copper (Cu), or an alloy thereof, but is not limited thereto.

The second p-type electrode 135 is disposed on the second p-type semiconductor layer 133. The second p-type electrode 135 may be disposed on the upper surface of the second p-type semiconductor layer 133. The second p-type electrode 135 is an electrode which electrically connects the power line VDD and the second p-type semiconductor layer 133. The second p-type electrode 135 may be configured by a conductive material, for example, a transparent conductive material, such as indium tin oxide (ITO) or indium zinc oxide (IZO) or an opaque conductive material, such as titanium (Ti), gold (Au), silver (Ag), copper (Cu), or an alloy thereof, but is not limited thereto.

Next, the second encapsulation layer 136 which encloses the second n-type semiconductor layer 131, the second light emitting layer 132, the second p-type semiconductor layer 133, the second n-type electrode 134, and the second p-type electrode 135 is disposed. The second encapsulation layer 136 is formed of an insulating material to protect the second n-type semiconductor layer 131, the second light emitting layer 132, and the second p-type semiconductor layer 133. In the second encapsulation layer 136, a contact hole which exposes the second n-type electrode 134 and the second p-type electrode 135 is formed to electrically connect the first connection electrode CE1 and the second connection electrode CE2 to the second n-type electrode 134 and the second p-type electrode 135.

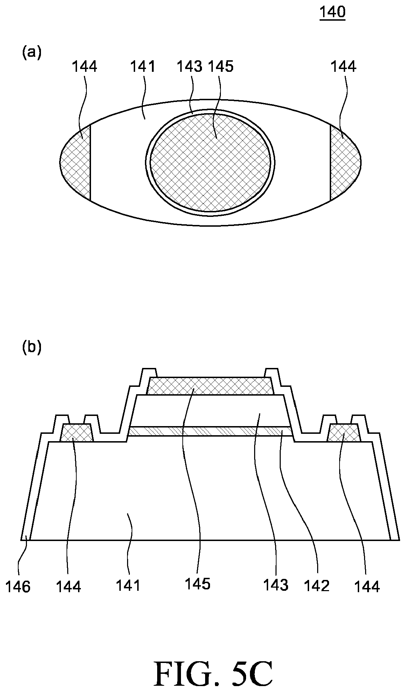

Referring to FIG. 5C, the third light emitting diode 140 includes a third n-type semiconductor layer 141, a third light emitting layer 142, a third p-type semiconductor layer 143, a third n-type electrode 144 and a third p-type electrode 145. A third encapsulation layer 146 may be disposed over the third light emitting diode 140.

The third n-type semiconductor layer 141 is disposed on the adhesive layer 116 and the third p-type semiconductor layer 143 is disposed on the third n-type semiconductor layer 141. The third n-type semiconductor layer 141 and the third p-type semiconductor layer 143 may be layers formed by doping n-type and p-type impurities into a specific material. For example, the third n-type semiconductor layer 141 and the third p-type semiconductor layer 143 may be layers formed by doping n-type and p-type impurities into a material such as gallium nitride (GaN), indium aluminum phosphide (InAlP), or gallium arsenide (GaAs). The p-type impurity may be magnesium, zinc (Zn), beryllium (Be), and the like, and the n-type impurity may be silicon (Si), germanium, tin (Sn), and the like, but are not limited thereto.

The third light emitting layer 142 is disposed between the third n-type semiconductor layer 141 and the third p-type semiconductor layer 143. The third light emitting layer 142 is supplied with holes and electrons from the third n-type semiconductor layer 141 and the third p-type semiconductor layer 143 to emit light. The third light emitting layer 142 may be formed by a single layer or a multi-quantum well (MQW) structure, and for example, may be formed of indium gallium nitride (InGaN) or gallium nitride (GaN), but is not limited thereto.

The third n-type electrode 144 is disposed on the third n-type semiconductor layer 141. The third n-type electrode 144 is an electrode which electrically connects the driving transistor DT and the third n-type semiconductor layer 141. The third n-type electrode 144 may be disposed on an upper surface of the third n-type semiconductor layer 141 which is exposed from the third light emitting layer 142 and the third p-type semiconductor layer 143. For example, the third n-type electrode 144 may be disposed to be adjacent to both end portions of the upper surface of the third n-type semiconductor layer 141 in a major axis direction on the upper surface of the third n-type semiconductor layer 141 formed with an elliptical planar shape. The third n-type electrode 144 may be configured by a conductive material, for example, a transparent conductive material, such as indium tin oxide (ITO) or indium zinc oxide (IZO) or an opaque conductive material, such as titanium (Ti), gold (Au), silver (Ag), copper (Cu), or an alloy thereof, but is not limited thereto.

The third p-type electrode 145 is disposed on the third p-type semiconductor layer 143. The third p-type electrode 145 may be disposed on the upper surface of the third p-type semiconductor layer 143. The third p-type electrode 145 is an electrode which electrically connects the power line VDD and the third p-type semiconductor layer 143. The third p-type electrode 145 may be configured by a conductive material, for example, a transparent conductive material, such as indium tin oxide (ITO) or indium zinc oxide (IZO) or an opaque conductive material, such as titanium (Ti), gold (Au), silver (Ag), copper (Cu), or an alloy thereof, but is not limited thereto.

Next, the third encapsulation layer 146 which encloses the third n-type semiconductor layer 141, the third light emitting layer 142, the third p-type semiconductor layer 143, the third n-type electrode 144, and the third p-type electrode 145 is disposed. The third encapsulation layer 146 is formed of an insulating material to protect the third n-type semiconductor layer 141, the third light emitting layer 142, and the third p-type semiconductor layer 143. In the third encapsulation layer 146, a contact hole which exposes the third n-type electrode 144 and the third p-type electrode 145 is formed to electrically connect the first connection electrode CE1 and the second connection electrode CE2 to the third n-type electrode 144 and the third p-type electrode 145.

In the meantime, the first light emitting diode 120, the second light emitting diode 130, and the third light emitting diode 140 may be formed with different shapes. Each of the plurality of light emitting diodes LED commonly includes the n-type semiconductor layers 121, 131, and 141, the light emitting layers 122, 132, and 142, the p-type semiconductor layers 123, 133, and 143, the n-type electrodes 124, 134, and 144, the p-type electrodes 125, 135, and 145, and the encapsulation layers 126, 136, and 146. However, some components may have different shapes.

For example, a planar shape of each of the first n-type semiconductor layer 121, the first light emitting layer 122, the first p-type semiconductor layer 123, the first n-type electrode 124, and the first p-type electrode 125 of the first light emitting diode 120 may be a circular shape. Among them, the first n-type electrode 124 is disposed along a periphery of the first n-type semiconductor layer 121 to be formed with a closed-loop circular electrode. The first p-type electrode 125 may be formed to have a shape corresponding to the upper surface of the first p-type semiconductor layer 123.

For example, a planar shape of the second n-type semiconductor layer 131, the second p-type semiconductor layer 133, and the second p-type electrode 135 of the second light emitting diode 130 may be an elliptical shape. At this time, the major axis direction of the second n-type semiconductor layer 131 may be configured to be different from the major axis direction of the second p-type semiconductor layer 133. For example, when the second n-type semiconductor layer 131 has an elliptical shape having a major axis in a horizontal direction, the second p-type semiconductor layer 133 may have an elliptical shape having a major axis in the vertical direction. The second n-type electrode 134 may be disposed to both end portions of the second n-type semiconductor layer 131 in a major axis direction on the upper surface of the second n-type semiconductor layer 131, respectively. Accordingly, the plurality of second n-type electrodes 134 disposed on both end portions of the second n-type semiconductor layer 131 may be formed in a semi-circular shape. Finally, the second p-type electrode 135 may be formed to have an elliptical shape which is the same as the upper surface of the second p-type semiconductor layer 133.

For example, planar shapes of the third n-type semiconductor layer 141, the third p-type semiconductor layer 143, and the third p-type electrode 145 of the third light emitting diode 140 may be an elliptical shape. Unlike the second light emitting diode 130, in the third light emitting diode 140, the major axis direction of the third n-type semiconductor layer 141 and the major axis direction of the third p-type semiconductor layer 143 may be configured to be same. The third n-type electrode 144 is disposed on both end portions of the third n-type semiconductor layer 141 in a major axis direction on the upper surface of the third n-type semiconductor layer 141, respectively, and may be formed in a semi-circular shape. The third p-type electrode 145 may be formed to have an elliptical shape which is the same as the upper surface of the third p-type semiconductor layer 143.

In the display device 100 according to the exemplary embodiment of the present specification, the first light emitting diode 120, the second light emitting diode 130, and the third light emitting diode 140 are configured to have different shapes, respectively, to distinguish the plurality of light emitting diodes LED. For example, when the light emitting diode LED is self-assembled, the plurality of light emitting diodes LED is formed to have different shapes to be self-assembled in a position corresponding to each of the plurality of sub pixels SP. However, the shapes of the plurality of light emitting diodes LED are illustrative, so that it is not limited thereto.

The second planarization layer 117 and the third planarization layer 118 are disposed on the adhesive layer 116. The second planarization layer 117 overlaps a part of side surface portions of the plurality of light emitting diodes LED to fix and protect the plurality of light emitting diodes LED. Specifically, even though in FIG. 4, it is illustrated that the first encapsulation layer 126 encloses all the side surfaces of the first n-type semiconductor layer 121, a part of the side surface of the first n-type semiconductor layer 121 may be exposed from the first encapsulation layer 126. The light emitting diode LED manufactured on the wafer is separated from the wafer to be transferred onto the display panel PN. However, during the process of separating the light emitting diode LED from the wafer, a part of the encapsulation layers 126, 136, and 146 may be torn. For example, a part of the first encapsulation layer 126 which is adjacent to a lower edge of the first n-type semiconductor layer 121 of the first light emitting diode 120 is torn during the process of separating the first light emitting diode 120 from the wafer. Accordingly, a part of a lower side surface of the first n-type semiconductor layer 121 may be exposed to the outside. Parts of the encapsulation layers 136 and 146 are also torn so that parts of the side surfaces of the n-type semiconductor layers 131 and 141 of the second light emitting diode 130 and the third light emitting diode 140 may be exposed. However, even though the lower portion of the first light emitting diode 120 is exposed from the first encapsulation layer 126, the first connection electrode CE1 and the second connection electrode CE2 are formed after forming the second planarization layer 117 which covers the side surface of the first n-type semiconductor layer 121. Accordingly, a short defect may be reduced.

Further, the third planarization layer 118 is formed to cover upper portions of the second planarization layer 117 and the light emitting diode LED and a contact hole through which the n-type electrodes 124, 134, and 144 and the p-type electrodes 125, 135, and 145 of the light emitting diode LED are exposed may be formed. The n-type electrodes 124, 134, and 144 and the p-type electrodes 125, 135, and 145 of the light emitting diode LED are exposed from the third planarization layer 118. The third planarization layer 118 is partially disposed in an area between the n-type electrodes 124, 134, and 144 and the p-type electrodes 125, 135, and 145 of the light emitting diode LED. Accordingly, the short defect may be reduced.

The second planarization layer 117 and the third planarization layer 118 may be configured by a single layer or a double layer, and for example, may be formed of photo resist or an acrylic organic material, but is not limited thereto. Even though in the specification, it is described that the second planarization layer 117 and the third planarization layer 118 are disposed, the planarization layer may be formed by a single layer, but is not limited thereto. The second planarization layer 117 and the third planarization layer 118 may be configured to surround the light-emitting diode 120, 130 and 140 and a thickness of the second planarization layer 117 may be different from that of the light-emitting diode 120, 130 and 140. A step coverage may exist between the adhesive layer 116 and the second planarization layer 117 and may be in a contact hole through the adhesive layer 116, the second planarization layer and the third planarization layer. A step coverage may exist between the second planarization layer 117 and the third planarization layer 118 and may be in a contact hole through the adhesive, the second planarization layer and the third planarization layer. An interface between the second planarization layer 117 and the third planarization layer 118 may be in a different plane from a top surface of the light-emitting diode, e.g. be lower than the top surface of the light-emitting diode.

A plurality of connection electrodes CE are disposed on the third planarization layer 118. The plurality of connection electrodes CE includes a plurality of first connection electrodes CE1 and a second connection electrode CE2.

The first connection electrode CE1 is an electrode which is disposed in each of the plurality of sub pixels SP to electrically connect the light emitting diode LED and the driving transistor DT. The first connection electrode CE1 may be connected to the first reflective electrode RE1 through the contact hole formed in the third planarization layer 118, the second planarization layer 117, and the adhesive layer 116. Accordingly, the first connection electrode CE1 may be electrically connected to any one of the source electrode SE and the drain electrode DE of the driving transistor DT through the first reflective electrode RE1. The first connection electrode CE1 may be connected to the n-type electrodes 124, 134, and 144 of the plurality of light emitting diodes LED through a contact hole formed in the third planarization layer 118. Accordingly, the first connection electrode CE1 may electrically connect the driving transistor DT to the n-type electrodes 124, 134, and 144 and the n-type semiconductor layers 121, 131, and 141 of the plurality of light emitting diodes LED.

The second connection electrode CE2 is an electrode for electrically connecting the light emitting diode LED and the power line VDD. The second connection electrode CE2 may be connected to the second reflective electrode RE2 through the contact hole formed in the third planarization layer 118, the second planarization layer 117, and the adhesive layer 116. Accordingly, the second connection electrode CE2 may be electrically connected to the power line VDD through the second reflective electrode RE2. The second connection electrode CE2 may be connected to the p-type electrodes 125, 135, and 145 of the plurality of light emitting diodes LED through a contact hole formed in the third planarization layer 118. Accordingly, the second connection electrode CE2 may electrically connect the power line VDD and the p-type electrodes 125, 135, and 145 and the p-type semiconductor layers 123, 133, and 143 of the plurality of light emitting diodes LED. A signal may be supplied to the light-emitting diode via the first connection electrode CE1 and the second connection electrode CE2.

In the meantime, the first connection electrode CE1 which connects the driving transistor DT and the light emitting diode LED which are disposed in each of the plurality of sub pixels SP may be individually disposed in each of the plurality of sub pixels SP. The second connection electrodes CE2 which are disposed in each of the plurality of sub pixels SP to connect the power line VDD and the light emitting diode LED may be connected to each other. That is, a power voltage of the power line VDD is commonly applied to all the plurality of light emitting diodes LED of the plurality of sub pixels SP so that one second connection electrode CE2 may be disposed in all the plurality of sub pixels SP.

Referring to FIGS. 3 and 4, in each of the plurality of sub pixels SP, the first connection electrode CE1 may be formed to have a concave portion corresponding to the p-type electrodes 125, 135, and 145 to be connected only to the n-type electrodes 124, 134, and 144 of the light emitting diode LED, but not to be connected to the p-type electrodes 125, 135, and 145. The concave portion of the first connection electrode CE1 may overlap the p-type electrodes 125, 135, and 145 of each of the plurality of light emitting diodes LED. The second connection electrode CE2 convexly extends into the concave portion of the first connection electrode CE1 to be electrically connected to the p-type electrodes 125, 135, and 145 of the plurality of light emitting diodes LED. The convex portion of the second connection electrode CE2 may overlap the p-type electrodes 125, 135, and 145 of each of the plurality of light emitting diodes LED.

In the meantime, as the display device 100 according to the exemplary embodiment of the present disclosure, after self-assembling the plurality of light emitting diodes LED on a separate assembling substrate 200, the display device 100 may be manufactured by transferring the plurality of light emitting diodes LED self-assembled using the donor 300 onto the display panel PN from the assembling substrate 200.

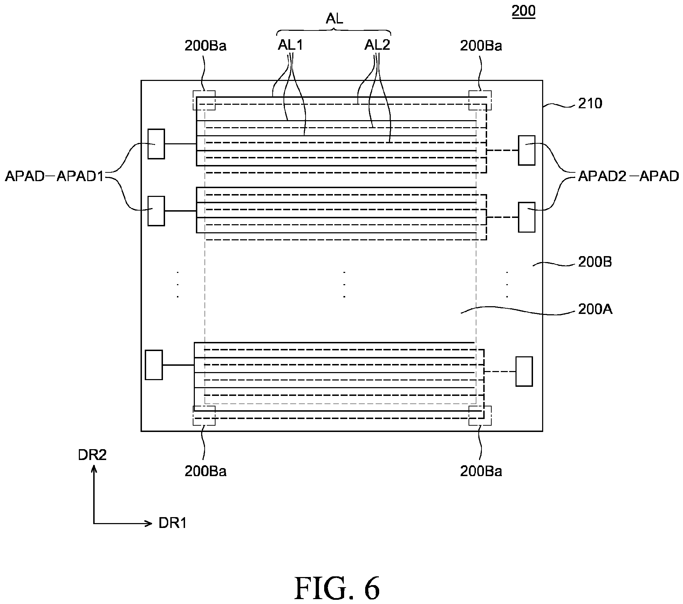

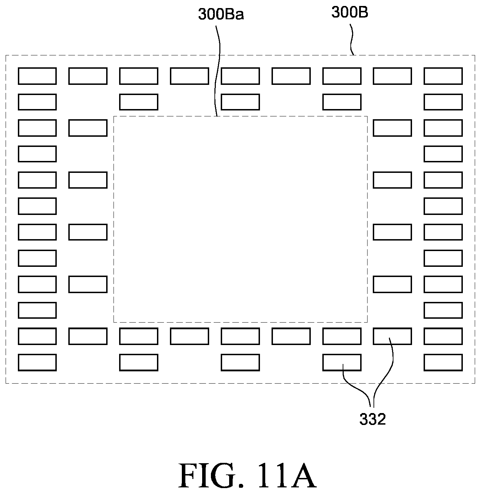

Hereinafter, after describing an assembling substrate 200 and a donor 300 according to an exemplary embodiment of the present disclosure, first, with reference to FIGS. 6 to 11B, a manufacturing method of a display device 100 according to an exemplary embodiment of the present disclosure will be described.

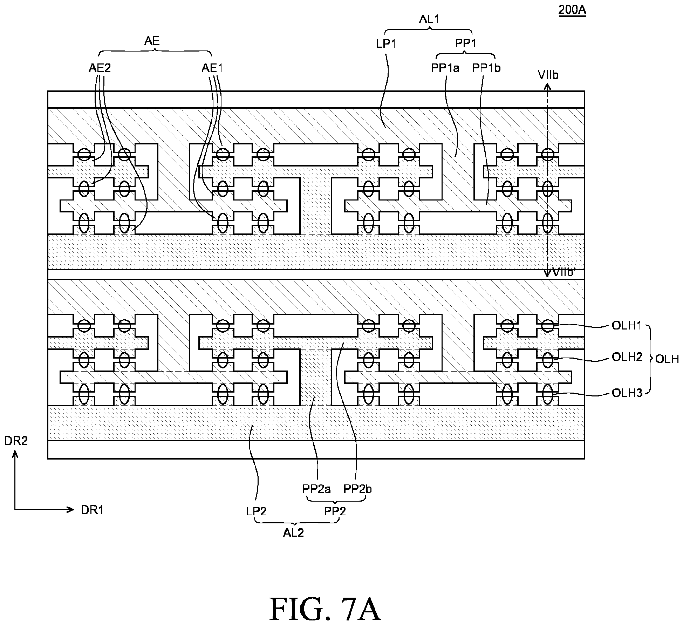

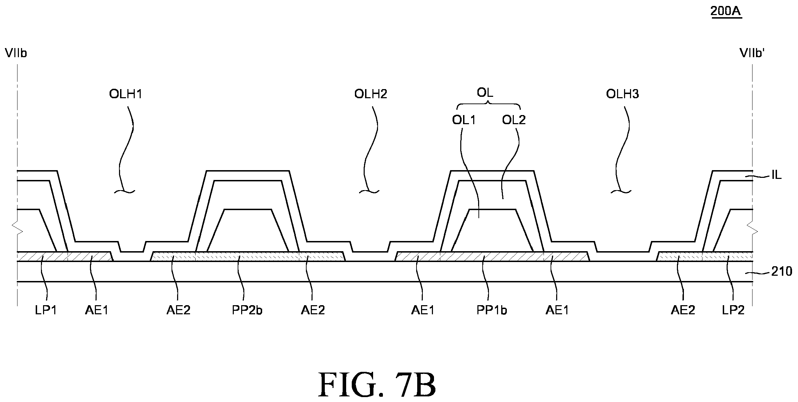

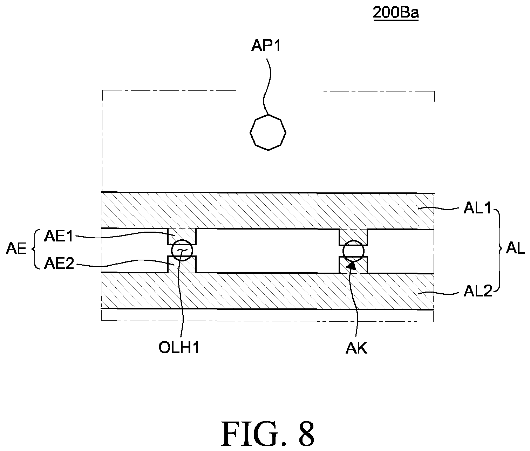

FIG. 6 is a plan view of an assembling substrate according to an exemplary embodiment of the present disclosure. FIG. 7A is an enlarged plan view of an assembly area of an assembling substrate of a display device according to an exemplary embodiment of the present disclosure. FIG. 7B is a cross-sectional view taken along VIIb-VIIb' of FIG. 7A according to an exemplary embodiment of the present disclosure. FIG. 8 is an enlarged plan view of a first alignment area of an assembling substrate of a display device according to an exemplary embodiment of the present disclosure.

Referring to FIG. 6, the assembling substrate 200 includes an assembly area 200A and an outer peripheral area 200B. The assembly area 200A is an area in which the plurality of light emitting diodes LED are self-assembled and a plurality of assembly lines AL and a plurality of assembly electrodes AE for self-assembling the light emitting diode LED are disposed. The outer peripheral area 200B is a remaining area excluding the assembly area 200A and a plurality of assembly pads, a plurality of alignment keys AK, and the like may be disposed therein.

Referring to FIGS. 6 to 7B, the assembling substrate 200 includes an assembly substrate 210, a plurality of assembly lines AL, a plurality of assembly electrodes AE, a plurality of assembly pads, an organic layer OL, and an assembly insulating layer IL.

First, referring to FIGS. 7A and 7B, in the assembly area 200A, the plurality of assembly lines AL and the plurality of assembly electrodes AE are disposed on the assembly substrate 210.

The plurality of assembly lines AL includes a plurality of first assembly lines AL1 and a plurality of second assembly lines AL2. The plurality of first assembly lines AL1 and the plurality of second assembly lines AL2 may be disposed to be spaced apart from each other with a predetermined interval. The plurality of first assembly lines AL1 and the plurality of second assembly lines AL2 may be alternately disposed. The plurality of first assembly lines AL1 and the plurality of second assembly lines AL2 are applied with different voltages so that an electric field may be formed between the plurality of first assembly lines AL1 and the plurality of second assembly lines AL2. The plurality of light emitting diodes LED may be self-assembled between the plurality of first assembly lines AL1 and the plurality of second assembly lines AL2 using the electric field formed between the plurality of first assembly lines AL1 and the plurality of second assembly lines AL2.

Each of the plurality of first assembly lines AL1 includes a first line parts LP1 and a plurality of first protrusion parts PP1. The first line part LP1 is a part which straightly extends from the assembly area 200A along a first direction DR1. The first line part LP1 extends from the assembly area 200A to the outer peripheral area 200B and may be electrically connected to the plurality of assembly pads of the outer peripheral area 200B.

The plurality of first protrusion parts PP1 are connected to one first line part LP1. The plurality of first protrusion parts PP1 may extend from one side surface of the first line part LP1 toward a second assembly line AL2 adjacent thereto. The plurality of first protrusion parts PP1 may be disposed to self-assemble the plurality of first light emitting diodes 120, the plurality of second light emitting diodes 130, and the plurality of third light emitting diodes 140 between one first assembly line AL1 and one second assembly line AL2 which are adjacent to each other. The plurality of first protrusion parts PP1 are disposed to be alternate with a plurality of second protrusion parts PP2 of the second assembly line AL2 to be described below and may form a plurality of electric fields to self-assemble the light emitting diode LED so as to correspond to the plurality of first sub pixels SP1, the plurality of second sub pixels SP2, and the plurality of third sub pixels SP3, respectively. Accordingly, the plurality of first protrusion parts PP1 are disposed in an area between the first assembly line AL1 and the second assembly line AL2 to self-assemble the first light emitting diode 120, the second light emitting diode 130, and the third light emitting diode 140 with an interval between the plurality of sub pixels SP.

If each of the plurality of first light emitting diodes 120, the plurality of second light emitting diodes 130, and the plurality of third light emitting diodes 140 is self-assembled using different assembly lines AL, all an assembly line AL for self-assembling the first light emitting diode 120, an assembly line AL for self-assembling the second light emitting diode 130, and an assembly line AL for self-assembling the third light emitting diode 140 are necessary. In this case, the number of the plurality of assembly lines AL is increased so that it may be difficult to secure a design area. Further, during a process of forming the assembly line AL so as to correspond to the interval between the sub pixels SP, a width of the assembly line AL is reduced to increase the resistance, which may lead to the deterioration of an assembly rate.

Accordingly, in order to self-assemble all the first light emitting diodes 120, the second light emitting diodes 130, and the third light emitting diodes 140 between one first assembly line AL1 and one second assembly line AL2 which are adjacent to each other, the plurality of first protrusion parts PP 1 may be connected to one first line part LP1.

Each of the plurality of first protrusion parts PP1 includes a first part PP1a and a second part PPlb. The first part PPla is a part extending from the first line part LP1 along a second direction DR2. The first part PP1a may be a connection member for transmitting a voltage to the second part PP1b. One end of the first part PP1a may be connected to the first line part LP1 and the other end may be connected to the second part PP1b.

The second part PP1b is a part which is connected to the other end of the first part PP1a and extends along the first direction DR1. The second part PP1b may be alternately disposed with the second protrusion part PP2 of the second assembly line AL2 while extending along the first direction DR1. The second part PPlb may be disposed in the area between a fourth part PP2b of the second protrusion part PP2 of the second assembly line AL2 and the second line part LP2. The second part PP1b is disposed to be adjacent to the fourth part PP2b of the second protrusion part PP2 and the second line part LP2 to form an electric field to self-assemble the plurality of first light emitting diodes 120, the plurality of second light emitting diodes 130, and the plurality of third light emitting diodes 140.

Each of the plurality of second assembly lines AL2 includes a second line part LP2 and a plurality of second protrusion parts PP2. The second line part LP2 is a part which straightly extends from the assembly area 200A along a first direction DR1. In the second direction DR2, the second line part LP2 may be disposed alternately with the first line part LP1. The second line part LP2 extends from the assembly area 200A to the outer peripheral area 200B and may be electrically connected to the plurality of assembly pads of the outer peripheral area 200B.

A plurality of second protrusion parts PP2 are connected to the second line part LP2. The plurality of second protrusion parts PP2 may extend from the other side surface of the second line part LP2 along the second direction DR2. Each of the plurality of second protrusion parts PP2 includes a third part PP2a and a fourth part PP2b. The third part PP2a is a part extending from the second line part LP2 along the second direction DR2. The third part PP2a may be a connection member for transmitting a voltage to the fourth part PP2b. One end of the third part PP2a may be connected to the second line part LP2 and the other end may be connected to the fourth part PP2b. The third part PP2a may be disposed alternately with the first part PP1a of the first assembly line AL1 adjacent thereto. Accordingly, the third part PP2a and the first part are alternately disposed so that the fourth part PP2b connected to the third part PP2a may be disposed alternately with the second part PP1b connected to the first part PP1a.

The fourth part PP2b is a part which is connected to the other end of the third part PP2a and extends along the first direction DR1. The fourth part PP2b extends along the first direction DR1 and may be alternately disposed with the second part PP1b of the first protrusion part PP1 of the first assembly line AL1. The fourth part PP2b may be disposed in the area between the second part PP1b of the first protrusion part PP1 of the first assembly line AL1 and the first line part LP1. In the second direction DR2, the fourth part PP2b of the second assembly line AL2 and the second part PP1b of the first assembly line AL1 may face each other. Accordingly, the fourth part PP2b of the second assembly line AL2 may form an electric field to self-assemble the plurality of first light emitting diodes 120, the plurality of second light emitting diodes 130, and the plurality of third light emitting diodes 140 together with the first line part LP1 and the second part PP1b of the first assembly line AL1 adjacent thereto.

The plurality of assembly electrodes AE include a plurality of first assembly electrodes AE1 and a plurality of second assembly electrodes AE2. The plurality of first assembly electrodes AE1 may be connected to the plurality of first assembly lines AL1 and the plurality of second assembly electrodes AE2 may be connected to the plurality of second assembly lines AL2. One pair of first assembly electrode AE1 and second assembly electrode AE2 is disposed to be adjacent to each other to form an electric field to self-assemble the light emitting diode LED. One pair of first assembly electrode AE1 and second assembly electrode AE2 may be disposed to correspond to a correct position in which the light emitting diode LED is transferred in the plurality of sub pixels SP.

Some of the plurality of first assembly electrodes AE1 may be disposed to protrude from one side surface of the first line part LP1 along the second direction DR2. The other part of the plurality of first assembly electrodes AE1 may be disposed to protrude from both side surfaces of the second part PP1b of the first protrusion part PP1 along the second direction DR2. For example, four first assembly electrodes AE1 may be connected to each of both side surfaces of one second part PP1b.

Some of the plurality of second assembly electrodes AE2 may be disposed to protrude from the other side surface of the second line part LP2 along the second direction DR2. Some second assembly electrodes AE2 connected to the second line part LP2 may face the first assembly electrode AE1 which protrudes from the second part PP1b of the first assembly line AL1 adjacent thereto. Some of the plurality of second assembly electrodes AE2 may be disposed to protrude from both side surfaces of the fourth part PP2b of the second protrusion part PP2 along the second direction DR2. The second assembly electrode AE2 protruding from one side surface of the fourth part PP2b may face the first assembly electrode AE1 which protrudes from the other side surface of the second part PP1b of the first assembly line AL1 adjacent thereto. The second assembly electrode AE2 protruding from the other side surface of the fourth part PP2b may face the first assembly electrode AE1 which protrudes from the first line part LP1 of the first assembly line AL1 adjacent thereto.

Any one of the first light emitting diode 120, the second light emitting diode 130, and the third light emitting diode 140 may be self-assembled between the first assembly electrode AE1 and the second assembly electrode AE2 which face each other, with an interval and an arrangement corresponding to the plurality of sub pixels SP. For example, the first light emitting diode 120 may be self-assembled between the first assembly electrode AE1 of the first line part LP1 and the second assembly electrode AE2 of the fourth part PP2b which face each other. The second light emitting diode 130 may be self-assembled between the first assembly electrode AE1 of the second part PP1b and the second assembly electrode AE2 of the fourth part PP2b which face each other. The third light emitting diode 140 may be self-assembled between the first assembly electrode AE1 of the second part PP1b and the second assembly electrode AE2 of the second line part LP2 which face each other.

Accordingly, the plurality of first protrusion parts PP1 and the plurality of second protrusion parts PP2 are alternately disposed between one first assembly line AL1 and the second assembly line AL2 which are adjacent to each other. By doing this, the first light emitting diode 120 of the first sub pixel SP1, the second light emitting diode 130 of the second sub pixel SP2, and the third light emitting diode 140 of the third sub pixel SP3 may be self-assembled at one time.

Referring to FIG. 6 again, a plurality of assembly pads are disposed on the assembling substrate 200 in the outer peripheral area 200B. The plurality of assembly pads include a plurality of first assembly pads APAD1 and a plurality of second assembly pads APAD2. The plurality of first assembly lines AL1 and the plurality of first assembly electrodes AE1 are connected to the plurality of first assembly pads APAD1 to be applied with a voltage. The plurality of second assembly lines AL2 and the plurality of second assembly electrodes AE2 are connected to the plurality of second assembly pads APAD2 to be applied with a voltage. Some first assembly lines AL1 among the plurality of first assembly lines AL1 may be connected to one first assembly pad APAD1 and some second assembly lines AL2 among the plurality of second assembly lines AL2 may be connected to one second assembly pad APAD2.

Next, the organic layer OL including a plurality of openings OLH is disposed on the plurality of assembly lines AL and the plurality of assembly electrodes AE. The organic layer OL includes a first organic layer OL1 and a second organic layer OL2. The first organic layer OL1 is disposed on the plurality of assembly lines AL and the second organic layer OL2 is disposed on the first organic layer OL1. A thickness of the organic layer OL which can be formed by one process is limited. If the thickness of the organic layer OL is equal to or lower than a predetermined level, the light emitting diode LED which is self-assembled in the opening OLH of the organic layer OL may not be properly seated in the opening OLH. In contrast, when the thickness of the organic layer is excessively thick, it is difficult to attach the light emitting diode LED which is self-assembled in the opening OLH of the organic layer OL to the donor 300. Therefore, the thickness of the organic layer OL may be adjusted by forming a plurality of organic layers OL. The organic layer OL may at least have a thickness smaller than a height of the light emitting diode LED. Even though in FIG. 7B, it is illustrated that the organic layer OL includes a first organic layer OL1 and a second organic layer OL2, the organic layer OL may be formed as a single layer or further include an additional organic layer OL, in addition to the first organic layer OL1 and the second organic layer OL2. However, it is not limited thereto.

The organic layer OL includes a plurality of openings OLH. Each of the plurality of openings OLH which is formed by opening a part of the organic layer OL is an area in which the plurality of light emitting diodes LED is self-assembled. The plurality of openings OLH may be disposed so as to overlap an area between one pair of the first assembly electrode AE1 and the second assembly electrode AE2. Each of the plurality of openings OLH may be formed in a position of the display device 100 corresponding to each of the plurality of sub pixels SP, later. The plurality of openings OLH may be disposed to correspond to the plurality of sub pixels SP one to one and the light emitting diode LED which is self-assembled in the plurality of openings OLH may be transferred onto the plurality of sub pixels SP as it is.

The plurality of openings OLH includes a plurality of first openings OLH1, a plurality of second openings OLH2, and a plurality of third openings OLH3. Each of the plurality of first openings OLH1, the plurality of second openings OLH2, and the plurality of third openings OLH3 may be disposed so as to correspond to the plurality of first sub pixels SP1, the plurality of second sub pixels SP2, and the plurality of third sub pixels SP3.

The plurality of first openings OLH1 has a shape corresponding to a planar shape of the first light emitting diode 120. The plurality of second openings OLH2 has a shape corresponding to a planar shape of the second light emitting diode 130. The plurality of third openings OLH3 has a shape corresponding to a planar shape of the third light emitting diode 140. For example, the first opening OLH1 is formed to have a circular shape so that only the first light emitting diode 120 may be self-assembled in the first opening OLH1 and the second opening OLH2 is formed to have an elliptical shape so that only the second light emitting diode 130 may be self-assembled in the second opening OLH2. The third opening OLH3 is formed to have an elliptical shape having a major axis longer than that of the second opening OLH2 so that only the third light emitting diode 140 may be self-assembled in the third opening OLH3. Accordingly, the first opening OLH1, the second opening OLH2, and the third opening OLH3 are formed to have shapes corresponding to the first light emitting diode 120, the second light emitting diode 130, and the third light emitting diode 140. Therefore, only a light emitting diode LED having a specific shape may be self-assembled in each opening OLH.

The assembly insulating layer II, is disposed on the organic layer OL. The assembly insulating layer IL protects the plurality of assembly lines AL, the plurality of assembly electrodes AE, and the organic layer OL from the fluid WT to suppress the defect such as corrosion of the plurality of assembly lines AL.

Referring to FIGS. 6 and 8 together, the outer peripheral area 200B includes one or more first alignment areas 200Ba. The first alignment area 200Ba is an area in which a plurality of first alignment patterns AP1 is disposed and a plurality of alignment keys AK are self-assembled. For example, the plurality of first alignment areas 200Ba may be formed to be adjacent to four corners of the assembly area 200A, respectively.

In the first alignment area 200Ba, the plurality of first alignment patterns AP1 are disposed on the assembling substrate 200. The plurality of first alignment patterns AP1 are marks for aligning the donor 300 to be described below and the assembling substrate 200. The assembling substrate 200 and the donor 300 may be aligned by aligning a plurality of first alignment patterns AP1 of the assembling substrate 200 and a plurality of second alignment patterns AP2 of the donor 300. For example, the plurality of first alignment patterns AP1 may be formed to have a donut shape.

In the first alignment area 200Ba, an assembly line AL and an assembly electrode AE may be further disposed on the assembling substrate 200. The assembly line AL disposed in the first alignment area 200Ba may apply a voltage to the assembly electrode AE to form an electric field for self-assembling the alignment key AK in the assembly electrode AE.

The alignment key AK may be self-assembled in an area between the assembly electrodes AE of the first alignment area 200Ba. The alignment key AK may be transferred to the donor 300 together with the plurality of light emitting diodes LED and the alignment key AK transferred to the donor 300 may be used to align the donor 300 and the display panel PN. That is, the alignment key AK is a mark for aligning the donor 300 and the display panel PN. The alignment key AK may be formed of the same material as at least a part of materials which form the light emitting diode LED. For example, the first light emitting diode 120 may be used as the alignment key AK. In this case, the first opening OLH1 of the organic layer OL may be formed on the assembly electrode AE to self-assemble only the first light emitting diode 120 which serves as the alignment key AK.

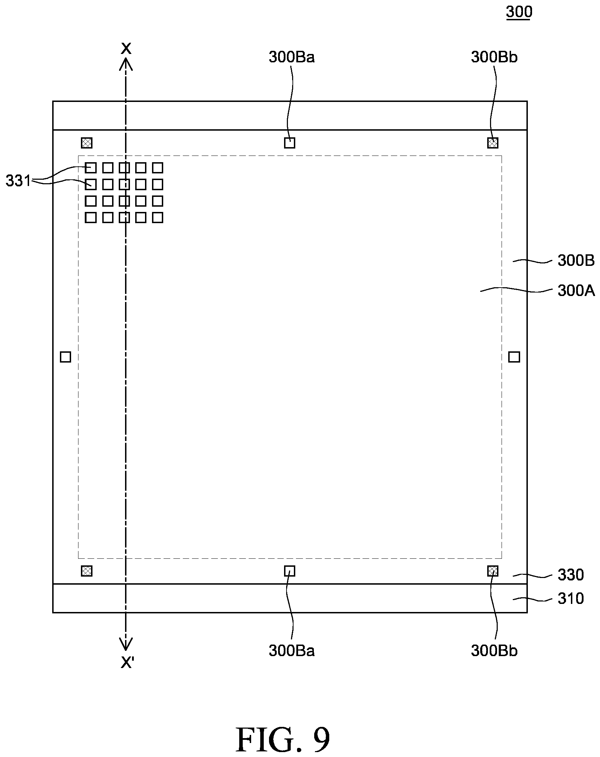

Hereinafter, the donor 300 according to the exemplary embodiment of the present disclosure will be described in more detail with reference to FIGS. 9 to 11B.

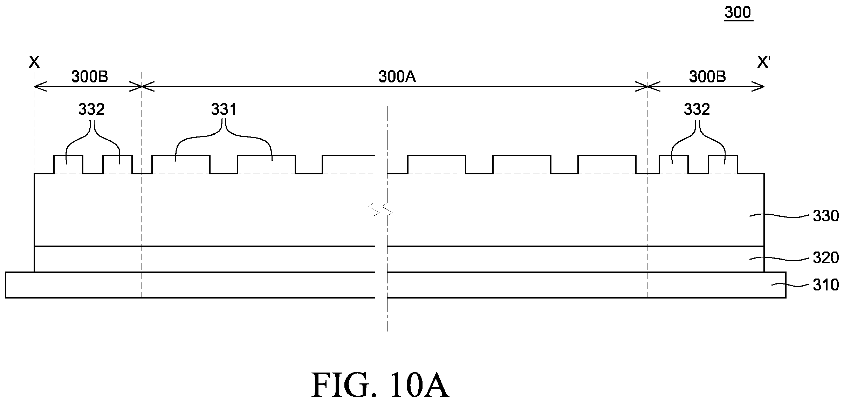

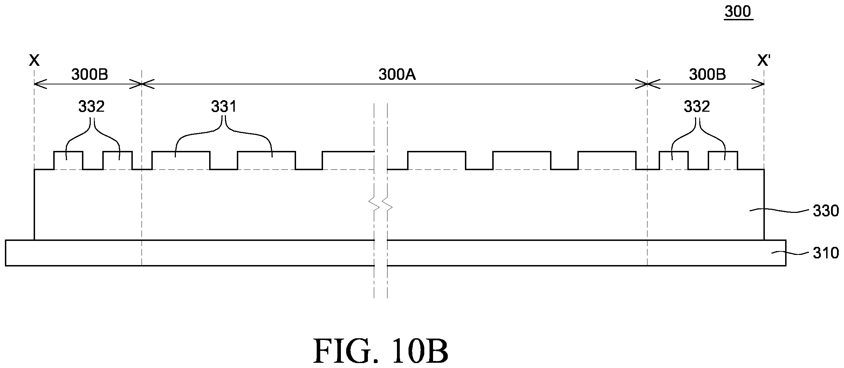

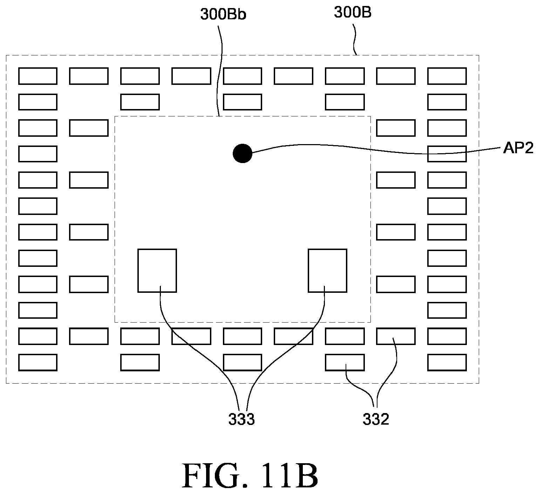

FIG. 9 is a plan view of a donor according to an exemplary embodiment of the present disclosure. FIGS. 10A and 10B are cross-sectional views taken along the line X-X' of FIG. 9 according to an exemplary embodiment of the present disclosure. FIG. 11A is an enlarged plan view of a displacement measuring area of a donor according to an exemplary embodiment of the present disclosure. FIG. 11B is an enlarged plan view of a second alignment area of a donor according to an exemplary embodiment of the present disclosure.

Referring to FIGS. 9 to 10B, the donor 300 includes a base substrate 310, a resin layer 330, a plurality of chip protrusions 331, a plurality of dummy protrusions 332, and a plurality of alignment protrusions 333. The donor 300 may optionally include an adhesive layer 320.

First, the base substrate 310 is a configuration for supporting various components included in the donor 300. The base substrate 310 may be at least formed of a material solider than the resin layer 330 to reduce a warpage of the resin layer 330. The base substrate 310 is disposed below the resin layer 330 to support the resin layer 330 and the plurality of chip protrusions 331, the plurality of dummy protrusions 332, and the plurality of alignment protrusions 333 disposed on the resin layer 330. The base substrate 310 may be formed of a transparent material with rigidity, and for example, formed of glass. As another example, the base substrate 310 may include polymer or plastic or may also be formed of poly carbonate (PC) or polyethylene terephthalate (PET), but is not limited thereto.

In the meantime, when the base substrate 310 of the donor 300 is formed of glass, an edge portion of the base substrate 310 may be smoothly processed to be used. When the donor 300 is separated from the assembling substrate 200 or the display panel PN, the separation may sequentially start from one edge of the donor 300. That is, the donor 300 may be previously peeled from the assembling substrate 200 or the display panel PN and the donor 300 may be bent during the previous peeling process of the donor 300. However, the edge part of the base substrate 310 formed of glass is vulnerable to the bending so that the base substrate may be cracked. For example, there is a minute crack in the edge part of the base substrate 310 which is formed during the process of cutting the base substrate 310 and the crack may propagate to the entire base substrate 310 due to the stress caused while the donor 300 is bent. Accordingly, the edge part of the base substrate 310 is smoothly processed by mechanically polishing the edge part of the base substrate 310 or the chemical processing to remove the minute crack and increase the reliability of the base substrate 310.

Next, referring to FIGS. 10A and 10B, a separate adhesive layer 320 may be formed between the base substrate 310 and the resin layer 330 or the resin layer 330 may be directly formed on the base substrate 310. The adhesive layer 320 bonds the resin layer 330 and the base substrate 310. The adhesive layer 320 may be formed of a material having adhesiveness and for example, may be formed of an optically clear adhesive (OCA), a pressure sensitive adhesive (PSA), or the like, but is not limited thereto.

However, as illustrated in FIG. 10B, the adhesive layer 320 may be omitted depending on the design. For example, the resin layer 330 may be formed by immediately coating a material which forms the resin layer 330 on the base substrate 310 and then curing the material. In this case, even though the adhesive layer 320 is not disposed, the resin layer 330 may be attached onto the base substrate 310 so that the adhesive layer 320 may be omitted depending on the design, but is not limited thereto.

The resin layer 330 is disposed on the base substrate 310. The resin layer 330 may be formed only in a part of the base substrate 310, rather than the entire base substrate 310. The resin layer 330 may support the plurality of chip protrusions 331 to which the plurality of light emitting diodes LED are attached, during the transferring process. The resin layer 330 is formed by a polymer material having viscoelasticity, for example, the resin layer 330 may be configured by poly dimethyl siloxane (PDMS), poly urethane acrylate (PUA), polyethylene glycol (PEG), polymethylmethacrylate (PMMA), polystyrene (PS), epoxy resin, urethane resin, acrylic resin, or the like. However, it is not limited thereto.

The resin layer 330 includes a transferring area 300A and a non-transferring area 300B. The transferring area 300A is an area in which the plurality of chip protrusions 331 are disposed. The transferring area 300A is an area in which the plurality of chip protrusions 331 attached with the plurality of light emitting diodes LED are disposed and may be disposed so as to overlap at least a part of the assembly area 200A of the assembling substrate 200 or the active area AA of the display panel PN during the transferring process.

The non-transferring area 300B is an area in which the plurality of dummy protrusions 332 and the plurality of alignment protrusions 333 are disposed. The non-transferring area 300B includes a displacement measuring area 300Ba and a second alignment area 300Bb. The displacement measuring area 300Ba is an area for measuring a flatness of the donor 300 and the second alignment area 300Bb is an area for aligning the assembling substrate 200 or the display panel PN and the donor 300.

Next, the plurality of chip protrusions 331 is disposed on the resin layer 330 in the transferring area 300A. The plurality of chip protrusions 331 are protrusions to which the plurality of light emitting diodes LEDs are temporarily attached and may extend from one surface of the resin layer 330. The plurality of chip protrusions 331 may be integrally formed with the resin layer 330 and may be formed of a polymer material having viscoelasticity, which is the same as the resin layer 330. For example, the plurality of chip protrusions 331 may be formed of poly dimethyl siloxane (PDMS), poly urethane acrylate (PUA), polyethylene glycol (PEG), polymethylmethacrylate (PMMS), polystyrene (PS), epoxy resin, urethane resin, acrylic resin, or the like, but is not limited thereto.

The plurality of light emitting diodes LED may be temporarily attached onto upper surfaces of the plurality of chip protrusions 331. The plurality of light emitting diodes LED which are self-assembled on the assembling substrate 200 may be transferred onto the upper surfaces of the plurality of chip protrusions 331. The plurality of light emitting diodes LED may be temporarily attached onto the upper surfaces of the plurality of chip protrusions 331 before being transferred onto the display panel PN.

At this time, the plurality of light emitting diodes LED included in one pixel PX may be transferred together onto one chip protrusion 331. For example, one pixel PX includes two first sub pixels SP1, two second sub pixels SP2, and two third sub pixels SP3 and six light emitting diodes LED included in each sub pixel SP may be disposed on one chip protrusion 331. However, the number of light emitting diodes LED to be disposed on one chip protrusion 331 may vary depending on the design, but is not limited thereto.

Referring to FIGS. 11A and 11B together, in the non-transferring area 300B, the plurality of dummy protrusions 332 are disposed on the resin layer 330. The plurality of dummy protrusions 332 may improve the bonding strength of the assembling substrate 200 and the donor 300 during the transferring process and minimize the deformation of the plurality of chip protrusions 331 due to the shock which is applied to the donor 300. For example, after bonding the assembling substrate 200 and the donor 300, when the plurality of light emitting diodes LED is transferred onto the donor 300, the plurality of light emitting diodes LED moves onto the donor 300 to apply the shock to the donor 300. The plurality of dummy protrusions 332 of the non-transferring area 300B which are disposed to enclose the transferring area 300A may reduce the deformation of the resin layer 330 and the plurality of chip protrusions 331 of the transferring area 300A due to the shock while maintaining a bonded state with the assembling substrate 200. Further, the plurality of dummy protrusions 332 are in contact with the organic layer OL of the assembling substrate 200 to maintain the bonded state of the assembling substrate 200 and the donor 300. The plurality of dummy protrusions 332 may be formed to have different shapes and different sizes from those of the chip protrusion 331, but is not limited thereto.

Referring to FIG. 11A, the plurality of displacement measuring areas 300Ba are disposed in the non-transferring area 300B. The displacement measuring area 300Ba is an area for aligning parallelism of the donor 300 and may be an empty space in which a separate protrusion is not disposed. In the displacement measuring area 300Ba, only the resin layer 330 is disposed so that the displacement measuring area 300Ba is a transparent area through which laser is transmitted. The parallelism of the donor 300 may be aligned using laser which passes through the displacement measuring area 300Ba. In this case, in order to measure the parallelism of the donor 300, the displacement measuring area 300Ba may be disposed to be adjacent to an upper side, a lower side, a left side, and a right side of the transferring area 300A, respectively.

Referring to FIG. 11B, the plurality of second alignment areas 300Bb are disposed in the non-transferring area 300B. The second alignment area 300Bb is an area for aligning the assembling substrate 200 or the display panel PN and the donor 300. When the assembling substrate 200 and the donor 300 are bonded, the second alignment area 300Bb may correspond to the first alignment area 200Ba of the assembling substrate 200. The second alignment area 300Bb may be disposed to be adjacent to four corners of the transferring area 300A, respectively.

In the second alignment area 300Bb, a second alignment pattern AP2 is disposed on the resin layer 330. The second alignment pattern AP2 is a mark for aligning the assembling substrate 200 and the donor 300. The second alignment pattern AP2 and the first alignment pattern AP1 of the assembling substrate 200 are aligned to align the donor 300 and the assembling substrate 200. For example, the second alignment pattern AP2 may be a circular protrusion which is disposed on the resin layer 330. The circular second alignment pattern AP2 is aligned in an empty space in the donut-shaped first alignment pattern AP1 to align the donor 300 and the assembling substrate 200.

In the second alignment area 300Bb, an alignment protrusion 333 is disposed on the resin layer 330. The alignment protrusion 333 is a protrusion onto which the alignment key AK self-assembled on the assembling substrate 200 is transferred. The alignment key AK may be temporarily disposed on the alignment protrusion 333. The plurality of light emitting diodes LED on the assembling substrate 200 is transferred onto the chip protrusion 331 and simultaneously, the alignment key AK on the assembling substrate 200 may be transferred onto the alignment protrusion 333. The alignment key AK transferred onto the alignment protrusion 333 may be used to align the donor 300 and the display panel PN thereafter.

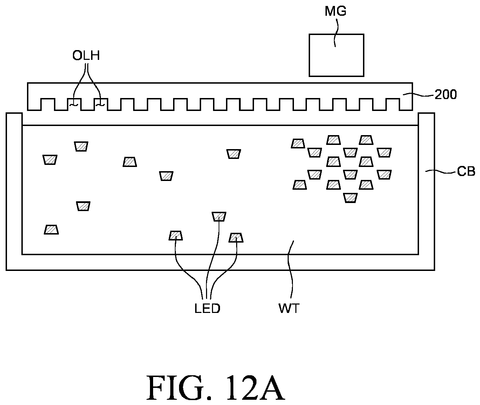

Hereinafter, a manufacturing method of a display device 100 according to an exemplary embodiment of the present disclosure will be described with reference to FIGS. 12A to 12H.

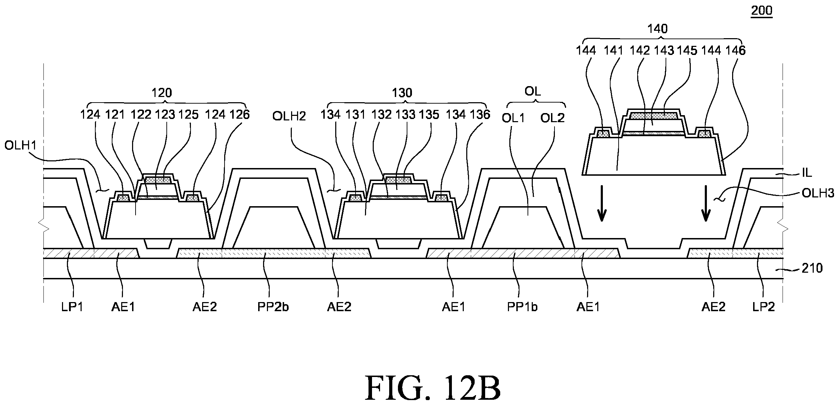

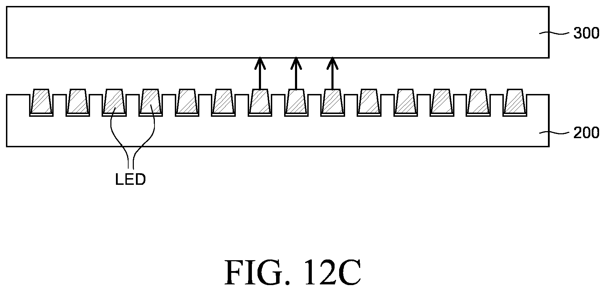

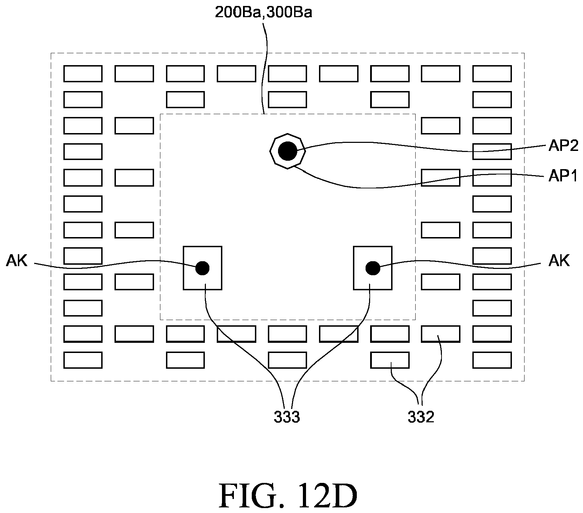

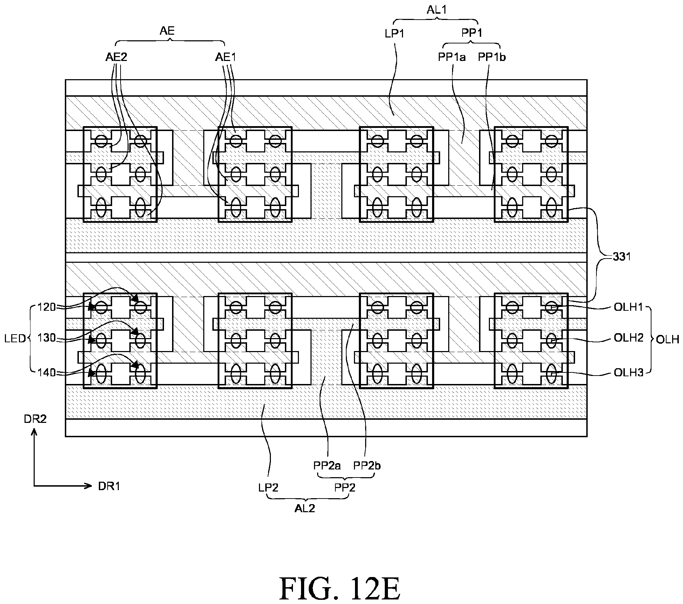

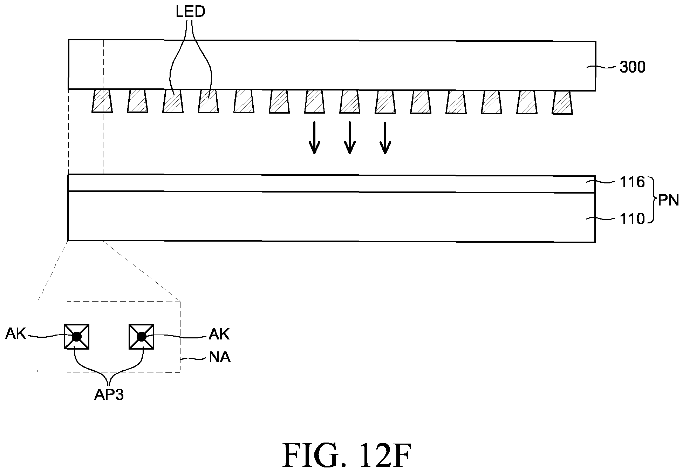

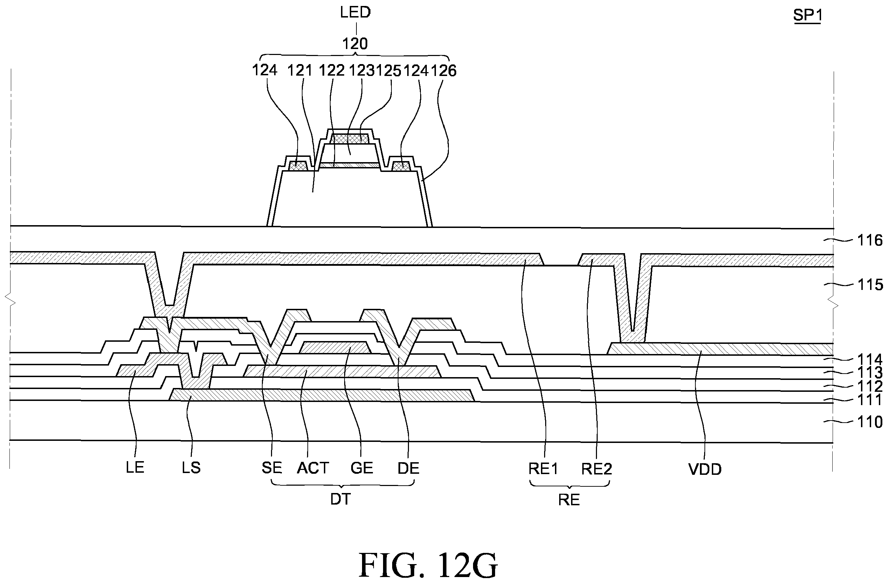

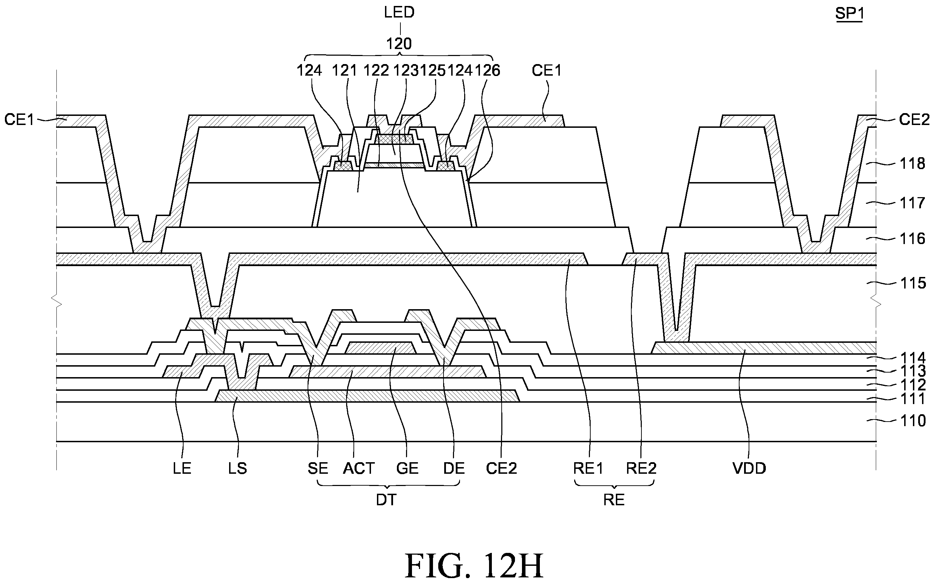

FIGS. 12A to 12H are process diagrams for explaining a method of manufacturing a display device according to an exemplary embodiment of the present disclosure. FIGS. 12A and 12B are views for explaining a process of self-assembling a light emitting diode LED on an assembling substrate 200 according to an exemplary embodiment of the present disclosure. FIG. 12C is a view for explaining a process of transferring the light emitting diode LED on the assembling substrate 200 onto the donor 300 according to an exemplary embodiment of the present disclosure. FIG. 12D is a plan view of a first alignment area 200Ba and a second alignment area 300Bb when the assembling substrate 200 and the donor 300 are bonded according to an exemplary embodiment of the present disclosure. FIG. 12E is a plan view of an assembly area 200A and a transferring area 300A when the assembling substrate 200 and the donor 300 are bonded according to an exemplary embodiment of the present disclosure. FIGS. 12F and 12G are views for explaining a process of transferring the light emitting diode LED on the donor 300 onto the display panel PN according to an exemplary embodiment of the present disclosure. FIG. 12H is a cross-sectional view of a display panel PN for explaining a process of forming a first connection electrode CE1 and a second connection electrode CE2 according to an exemplary embodiment of the present disclosure.

Referring to FIG. 12A, the plurality of light emitting diodes LED is self-assembled on the assembling substrate 200.

First, the plurality of light emitting diodes LED which are grown on the wafer is input into a chamber CB filled with a fluid WT. The fluid WT may include water and the chamber CB filled with fluid WT may have an open-top shape.

Next, the assembling substrate 200 may be located on the chamber CB filled with the light emitting diode LED. The assembling substrate 200 may be disposed such that the organic layer OL on which the plurality of openings OLH of the assembling substrate 200 is formed and the chamber CB face each other.

Next, a magnet MG may be located on the assembling substrate 200. The light emitting diodes LED sinking on the bottom of the chamber CB or floating may move toward the assembling substrate 200 by a magnetic force of the magnet MG.

At this time, the light emitting diode LED may include magnetic materials to move by the magnetic field. For example, any one of n-type electrodes 124, 134, and 144 of the light emitting diode LED or p-type electrodes 125, 135, and 145 includes a ferromagnetic material such as iron (Fe), cobalt (Co), or nickel (Ni) to align a direction of the light emitting diode LED directed to the magnet MG.

Next, referring to FIG. 12B, the light emitting diode LED which moves to the assembling substrate 200 by the magnet MG may be self-assembled to the assembling substrate 200 by an electric field formed between a plurality of assembly electrodes AE.

Specifically, a voltage is applied to the plurality of assembly lines AL and the plurality of assembly electrodes AE to self-assemble the plurality of light emitting diodes LED in the opening OLH of the organic layer OL. For example, different AC voltages are applied to the plurality of first assembly lines AL1 and the plurality of first assembly electrodes AE1 and the plurality of second assembly lines AL2 and the plurality of second assembly electrodes AE2 to form an electric field. The light emitting diode LED is dielectrically polarized by the electric field to have a polarity. The dielectrically polarized light emitting diode LED may move or may be fixed to a specific direction by dielectrophoresis (DEP), that is, an electric field. Accordingly, the plurality of light emitting diodes LED may be temporarily self-assembled in the opening OLH of the assembling substrate 200 using dielectrophoresis.

At this time, each of the second light emitting diode 130 and the third light emitting diode 140 having an elliptical shape may be aligned such that one pair of n-type electrodes is directed to adjacent assembly electrodes AE. For example, the second light emitting diode 130 is aligned such that one of one pair of second n-type electrodes 134 is directed to the first assembly electrode AE1 and the other one is directed to the second assembly electrode AE2. By doing this, the second light emitting diode may be self-assembled in the second opening OLH2.

After completing the self-assembling, the fluid WT may be evaporated from the assembling substrate 200. At this time, the electric field is formed between the assembly electrodes AE before completely evaporating the fluid WT to fix the light emitting diode LED into the opening OLH. When the drying of the assembling substrate 200 is completed, the electric field may be removed. At this time, even after removing the electric field, the light emitting diode LED may be temporarily fixed to the assembling substrate 200 by means of Van der Waals force.

Next, referring to FIGS. 12C to 12E, the plurality of light emitting diodes LED and the plurality of alignment keys AK of the assembling substrate 200 are transferred onto the donor 300.

First, referring to FIGS. 12C and 12D, the assembling substrate 200 and the donor 300 are aligned such that the plurality of light emitting diodes LED and the donor 300 face each other. At this time, the assembling substrate 200 and the donor 300 may be aligned by overlapping the first alignment area 200Ba of the assembling substrate 200 and the second alignment area 300Bb of the donor 300 to each other. For example, the assembling substrate 200 and the donor 300 may be aligned such that the first alignment pattern AP1 of the assembling substrate 200 and the second alignment pattern AP2 of the donor 300 overlap each other. The assembling substrate 200 and the donor 300 may be aligned such that the circular second alignment pattern AP2 is disposed in an empty space in the donut-shaped first alignment pattern AP1. In this case, the alignment key AK of the assembling substrate 200 may be aligned on the alignment protrusion 333 of the donor 300 to overlap each other.

Referring to FIG. 12E, when the first alignment pattern AP1 and the second alignment pattern AP2 are aligned, the plurality of chip protrusions 331 may be aligned so as to correspond to the plurality of light emitting diodes LED. Each of the plurality of chip protrusions 331 may be disposed above one pair of first light emitting diodes 120, one pair of second light emitting diodes 130, and one pair of third light emitting diodes 140.

Accordingly, after aligning the assembling substrate 200 and the donor 300, the assembling substrate 200 and the donor 300 are bonded so that the upper portion of the light emitting diode LED may be in contact with the donor 300. At this time, the donor 300 is formed of a material having adhesiveness so that upper portions of the plurality of light emitting diodes LED is adhered to the donor 300 to move from the assembling substrate 200 to the donor 300. The plurality of alignment keys AK may be also transferred to the alignment protrusion 333 of the donor 300 together with the plurality of light emitting diodes LED which is transferred to the plurality of chip protrusions 331.

Next, referring to FIG. 12F, the plurality of light emitting diodes LED on the donor 300 is transferred onto the adhesive layer 116 of the display panel PN.

First, the display panel PN with the adhesive layer 116 formed and the donor 300 are aligned. After disposing the donor 300 such that the plurality of light emitting diodes LED of the donor 300 faces the adhesive layer 116 of the display panel PN with each other, the display panel PN and the donor 300 may be aligned. When the display panel PN and the donor 300 are aligned, the alignment key AK which is temporarily attached onto the alignment protrusion 333 of the donor 300 is aligned with the third alignment pattern AP3 of the display panel PN to align the donor 300 and the display panel PN. The third alignment pattern AP3 is a pattern disposed in the non-active area NA of the display panel PN and may be formed of the same material as any one of the plurality of wiring lines or the plurality of electrodes disposed in the display panel PN. For example, the third alignment pattern AP3 may be formed in a quadrangular shape in which an X-shaped pattern is disposed therein. Therefore, the donor 300 and the display panel PN may be aligned to dispose the alignment key AK in a center of the X-shaped portion of the third alignment pattern AP3.

Further, referring to FIGS. 12F and 12G together, the donor 300 and the display panel 100 are bonded to transfer the light emitting diode LED on the donor 300 onto the adhesive layer 116. The plurality of light emitting diodes LED disposed on the donor 300 is disposed so as to correspond to the plurality of sub pixels SP so that all the light emitting diodes LED on the donor 300 may be transferred onto the display panel PN at one time without selectively transferring the light emitting diodes LED. The plurality of light emitting diodes LED which are transferred onto the display panel PN is attached onto the adhesive layer 116 to be temporarily fixed.

The alignment key AK may be transferred together with the plurality of light emitting diodes LED. The alignment key AK may be transferred onto the third alignment pattern AP3 of the non-active area NA. However, the alignment key AK which is transferred onto the display panel PN is not connected to a separate connection electrode CE so that it does not emit light.

Next, referring to FIG. 12H, after transferring the light emitting diode LED onto the adhesive layer 116 of the display panel PN, the first connection electrode CE1 and the second connection electrode CE2 are formed to electrically connect the light emitting diode LED to the driving transistor DT and the power line VDD.

First, the second planarization layer 117 and the third planarization layer 118 which cover the plurality of light emitting diodes LED are formed. A contact hole which exposes the n-type electrodes 124, 134, and 144 and the p-type electrodes 125, 135, and 145 of the plurality of light emitting diodes LED is formed in the third planarization layer 118. Further, a contact hole which exposes the first reflective electrode RE1 and a contact hole which exposes the second reflective electrode RE2 may be formed on the third planarization layer 118, the second planarization layer 117, and the adhesive layer 116.

Next, the first connection electrode CE1 and the second connection electrode CE2 may be formed on the third planarization layer 118. A conductive material layer is formed on a front surface of the substrate 110 and patterned to form the first connection electrode CE1 and the second connection electrode CE2.

Accordingly, in the display device 100 according to the exemplary embodiment of the present disclosure and a manufacturing method of the display device 100, the plurality of light emitting diodes LED are self-assembled on the assembling substrate 200 in an arrangement corresponding to the plurality of sub pixels SP. Thereafter, the plurality of light emitting diodes LED on the assembling substrate 200 may be transferred onto the display panel PN using the donor 300. When the light emitting diode LED is self-assembled using the electric field, a process of transferring the plurality of light emitting diodes LED from the wafer onto the donor 300 by aligning the plurality of light emitting diodes LED so as to correspond to the interval between the plurality of sub pixels SP may be omitted. Further, the light emitting diode LED may be easily self-assembled in a correct position using the electric field and the plurality of openings OLH to reduce an alignment error. Accordingly, the plurality of light emitting diodes LED are self-assembled using the assembling substrate 200 in an arrangement corresponding to the sub pixel SP and is transferred onto the display panel PN as it is. Accordingly, the alignment error of the plurality of light emitting diodes LED may be reduced and the transferring process may be simplified.

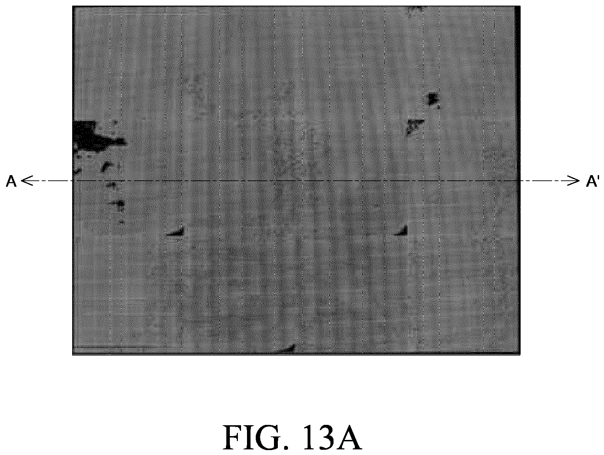

In the meantime, in the display device 100 according to the exemplary embodiment of the present disclosure and a manufacturing method of the display device 100, the plurality of light emitting diodes LED is not self-assembled on the assembling substrate 200 in the arrangement on the wafer, but is self-assembled in a random position. Accordingly, it is possible to reduce a wavelength deviation on the wafer from being displayed on the display panel PN as it is. Hereinafter, an effect of reducing a wavelength deviation will be described with reference to FIGS. 13A to 14B.

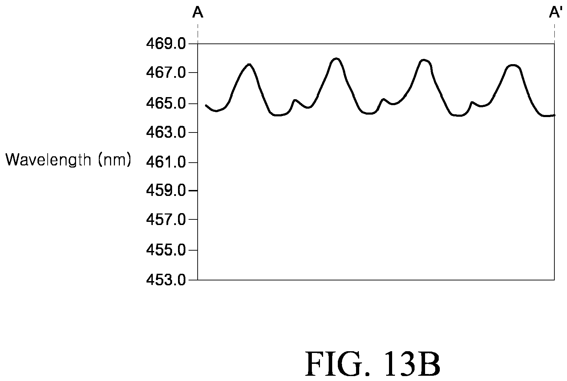

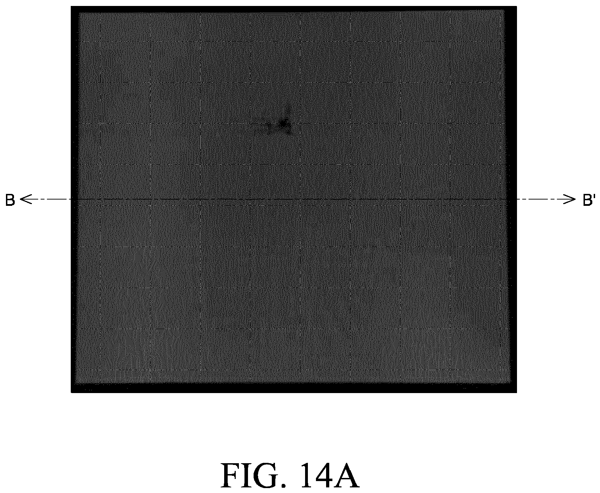

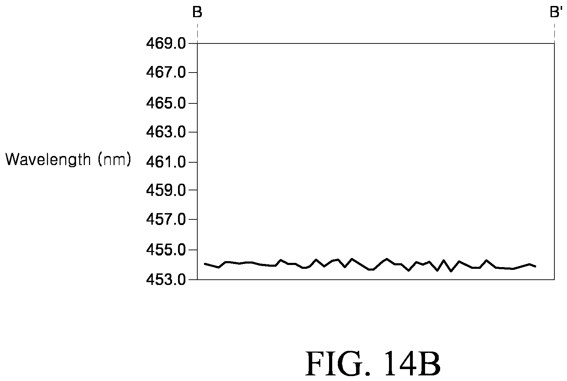

FIG. 13A is a view illustrating a screen of a display device according to a comparative embodiment. FIG. 13B is a graph illustrating a wavelength distribution measured along the line A-A' of FIG. 13A. FIG. 14A is a view illustrating a screen of a display device according to an exemplary embodiment of the present disclosure. FIG. 14B is a graph illustrating a wavelength distribution measured along the line B-B' of FIG. 14A according to an exemplary embodiment of the present disclosure.

A display device according to a comparative embodiment is a display device when the plurality of light emitting diodes LED on the wafer is transferred onto the donor 300 as it is and then transferred onto the display panel PN from the donor 300. The plurality of light emitting diodes LED may be disposed on the display panel PN as they are arranged on the wafer.

First, in the display device 100 according to the exemplary embodiment of the present disclosure and a manufacturing method of the display device 100, the plurality of light emitting diodes LED is self-assembled in a random position to be transferred onto the display panel PN. Accordingly, it is possible to reduce the wavelength deviation on the wafer from being displayed on the display panel PN as it is and improve the color uniformity.

The plurality of light emitting diodes LED which are grown on one wafer emits the same series of light. However, even the light emitting diodes LED which are grown on one wafer may have a slightly different wavelength of light which is actually emitted, due to the error of the process. For example, as the light emitting diode LED is more adjacent to a center or a corner of the wafer, light having a longer wavelength may be emitted and as the light emitting diode is more adjacent to an area between the center and the corner of the wafer, light having a shorter wavelength may be emitted.

Referring to FIGS. 13A and 13B, like the display device according to the comparative embodiment, when the light emitting diode LED on the wafer is transferred onto the donor 300 and the display panel PN as it is arranged on the wafer, the wavelength deviation on the wafer may be visible from the display panel PN as it is. Also, on the graph obtained by measuring the wavelength distribution along the line A-A', it may be confirmed that the wavelength of the plurality of light emitting diodes LED continuously varies in a sinewave form. Therefore, the wavelength deviation distribution on the wafer may be visible to a user who watches the display panel PN as it is.

Accordingly, in the display device 100 according to the exemplary embodiment of the present disclosure, the plurality of light emitting diodes LED which are grown on a plurality of wafers is input into one chamber CB and the light emitting diode is self-assembled in a random position using the electric field. Accordingly, light emitting diodes LED having a wavelength deviation may be uniformly distributed. That is, during the self-assembling, the plurality of light emitting diodes LED is uniformly mixed to be self-assembled so that recognition of color and luminance irregularity between the plurality of areas of the display panel PN onto which the light emitting diode LED is transferred from different donors 300 may be reduced. Accordingly, the wavelength deviation on the wafer may be not visible from the display panel PN, and the color uniformity of light emitted from the light emitting diode LED may be improved.

Specifically, referring to FIGS. 14A and 14B, in the display device 100 according to the exemplary embodiment of the present disclosure, the plurality of light emitting diodes LED having wavelength deviation are uniformly mixed to be transferred onto the display panel PN. Accordingly, the wavelength deviation distribution on the wafer may not be visible to the user. Specifically, also on the graph obtained by measuring the wavelength distribution along the line B-B', it may be confirmed that the wavelength distribution is uniformly formed. Accordingly, during the self-assembling process, the light emitting diodes LED may be randomly disposed, a wavelength deviation thereof may be relieved, and a color uniformity may be improved.

In the display device 100 according to the exemplary embodiment of the present disclosure and a manufacturing method of the display device 100, the interval between the plurality of light emitting diodes LED on one wafer may be reduced so that the number of light emitting diodes LED manufactured on one wafer may be increased. When the light emitting diode LED is directly transferred from the wafer onto the donor 300, laser is irradiated to transfer the light emitting diode LED onto the donor 300. During the selective transferring using laser, only some light emitting diodes LED, among the plurality of light emitting diodes LED may be transferred in the arrangement of the sub pixels SP. However, the shock applied when the laser is irradiated may damage the adjacent light emitting diode LED so that it is necessary to ensure the interval between the light emitting diode LED. However, the manufacturing method of the display device 100 according to the exemplary embodiment of the present disclosure uses a method of inputting all the plurality of light emitting diodes LED grown on one wafer into one chamber CB to be self-assembled. Therefore, it is not necessary to selectively detach the light emitting diode LED and the interval between the light emitting diodes LED may be also reduced. By doing this, a minimum interval between the light emitting diodes is reduced to increase the number of light emitting diodes LED which is formable on one wafer and reduce a manufacturing cost.

Further, as the number of light emitting diodes LED which is formable on one wafer is increased, a wafer having a smaller size may be used. The smaller the wafer, the smaller the wavelength deviation between the plurality of light emitting diodes LED disposed on the wafer. Accordingly, the display device 100 may be manufactured with a plurality of light emitting diodes with a reduced wavelength deviation using a smaller wafer so that a display quality and a color uniformity of the display device 100 may be improved.

In the display device 100 according to the exemplary embodiment of the present disclosure and the manufacturing method of the display device 100, the number of times of transferring required to manufacture one display device 100 may be reduced using a donor 300 having a larger size. First, as the size of the donor 300 is increased, a transferring tolerance is increased so that it is limited to increasing a size of the donor 300. Specifically, when the light emitting diode LED is directly transferred from the wafer onto the donor 300 in accordance with the arrangement of the sub pixel SP, an error generated during the transferring process and an error generated when the donor 300 is deformed by the temperature and the humidity are added. Therefore, the quality of the display device 100 may be degraded. In contrast, in the display device 100 according to the exemplary embodiment of the present disclosure and the manufacturing method of the display device 100, the plurality of light emitting diodes LED may be aligned in the sub pixel SP arrangement using the assembling substrate 200. The plurality of light emitting diodes LED aligned in the sub pixel SP arrangement are transferred onto the donor 300 as it is to reduce the error generated during the transferring process. Accordingly, the size of the donor 300 is enlarged to reduce the number of times of transferring required to manufacture one display device 100 and improve the production efficiency.

In the following a list of examples of the present disclosure is provided
1. A display device, comprising: a substrate (110) in which a pixel including a plurality of sub pixels (SP) is defined, an adhesive layer (116) on the substrate (110); and a plurality of light emitting diodes (120, 130, 140) being self-assembled and being transferred onto the adhesive layer (116) are disposed in the plurality of sub pixels (SP).
2. The display device according to example 1, wherein the plurality of light emitting diodes (120, 130, 140) include a first light emitting diode (120), a second light emitting diode (130), and a third light emitting diode (140) having different planar shapes.
3. The display device according to example 2, wherein the first light emitting diode (120) has a circular planar shape, and the first light emitting diode (120) includes: a first n-type semiconductor layer (121) in contact with an upper surface of the adhesive layer (116); a first light emitting layer (122) on the first n-type semiconductor layer (121); a first p-type semiconductor layer (123) on the first light emitting layer (122); a first n-type electrode (124) along a periphery of an upper surface of the first n-type semiconductor layer (121); and a first p-type electrode (125) on an upper surface of the first p-type semiconductor layer (123) and having a circular planar shape.
4. The display device according to example 2 or 3, wherein the second light emitting diode (130) has an elliptical planar shape, and the second light emitting diode (130) includes: a second n-type semiconductor layer (131) in contact with an upper surface of the adhesive layer (116) and has an elliptical planar shape; a second light emitting layer (132) on the second n-type semiconductor layer (131); a second p-type semiconductor layer (133) on the second light emitting layer (132) and has an elliptical planar shape; one pair of second n-type electrodes (134) adjacent to both end portions of the second n-type semiconductor layer (131) in a major axis direction of an upper surface of the second n-type semiconductor layer (131); and a second p-type electrode (135) on an upper surface of the second p-type semiconductor layer (133) and having an elliptical planar shape, and the major axis direction of the upper surface of the second n-type semiconductor layer (131) and a major axis direction of the upper surface of the second p-type semiconductor layer (133) are different.
5. The display device according to any one of the preceding examples 2, 3 or 4, wherein the third light emitting diode (140) has an elliptical planar shape having a different size from a planar shape of the second light emitting diode (130), the third light emitting diode (140) includes: a third n-type semiconductor layer (141) in contact with the upper surface of the adhesive layer (116) and has an elliptical planar shape; a third light emitting layer (142) on the third n-type semiconductor layer (141); a third p-type semiconductor layer (143) on the third light emitting layer (142) and has an elliptical planar shape; one pair of third n-type electrodes (144) adjacent to both end portions of the third n-type semiconductor layer (141) in a major axis direction of an upper surface of the third n-type semiconductor layer (141); and a third p-type electrode (145) on an upper surface of the third p-type semiconductor layer (143) and having an elliptical planar shape, and the major axis direction of the upper surface of the third n-type semiconductor layer (141) and a major axis direction of the upper surface of the third p-type semiconductor layer (143) are a same.
6. The display device according to any one of the preceding claims, wherein the plurality of light emitting diodes (120, 130, 140) are first self-assembled on an assembling substrate (200) in an arrangement corresponding to the plurality of sub pixels (SP) and then transferred onto the adhesive layer (116), preferably before being transferred onto the adhesive layer (116), the plurality of light emitting diodes (120, 130, 140) being self-assembled on the assembling substrate (200) are transferred onto a donor (300).
7. The display device according to example 6, wherein the self-assembling of the plurality of light emitting diodes (120, 130, 140) is achieved by applying a voltage to a plurality of assembly electrodes (AE) on the assembling substrate (200) to form an electric field and self-assembling the plurality of light emitting diodes (120, 130, 140) on the plurality of assembly electrodes (AE) with the electric field.
8. The display device according to any one of the preceding examples, comprising: a thin film transistor (DT) over the substrate (110 ); a reflective electrode (RE) over the thin film transistor (DT); a first planarization layer (115) between the thin film transistor (DT) and the reflective electrode (RE); a power line (VDD) between the thin film transistor (DT) and the first planarization layer (115); the adhesive layer (116) on the reflective electrode (RE); wherein the plurality of light-emitting diodes (120, 130, 140) is disposed on the adhesive layer (116) and connected to the thin film transistor (DT) via the reflective electrode (RE) and a first connection electrode (CE1), the light-emitting diode (120, 130, 140) comprising a first electrode (124, 134, 144) and a second electrode (125, 135, 145); an encapsulation layer (126, 136, 146) over each of the light-emitting diodes (120, 130, 140); a second planarization layer (117) over the adhesive layer (116); and a third planarization layer (118) over the encapsulation layer (126, 136, 146) and the second planarization layer (117) and a part of the third planarization layer (118) is between the first electrode (124, 134, 144) and the second electrode (125, 135, 145).
9. The display device according to any one of the preceding examples, wherein the second planarization layer (117) and the third planarization layer (118) surround the light-emitting diode (120, 130, 140) and/or a thickness of the second planarization layer (117) is different from a thickness of the light-emitting diode (120, 130, 140) and/or an interface between the second planarization layer (117) and the third planarization layer (118) is in a different plane from a top surface of the light-emitting diode (120, 130, 140).
10. The display device according to example 8 or 9, wherein a step coverage is between the adhesive layer (116) and the second planarization layer (117) and/or a step coverage is between the second planarization layer (117) and the third planarization layer (118), preferably the step coverage is in a contact hole through the adhesive layer (116), the second planarization layer (117), and the third planarization layer (118).
11. The display device according to any one of the preceding examples 8-10, further comprising a light shielding layer (LS) on the substrate (110), the thin film transistor (DT) comprises an active layer (ACT), and the light shielding layer (LS) overlaps at least one of the light-emitting diode (120, 130, 140), the active layer (ACT), or the reflective electrode (RE).
12. The display device according to any one of the examples 8, 9, 10 or 11, wherein the first connection electrode (CE1) and a second connection electrode (CE2) are connected to the light-emitting diode (120, 130, 140) to thereby supply a signal via the first connection electrode (CE1) and the second to the light-emitting diode (120, 130, 140).
13. A manufacturing method of a display device, comprising: self-assembling a plurality of light emitting diodes (120, 130, 140) on an assembling substrate (200); transferring the plurality of light emitting diodes (120, 130, 140) which are self-assembled on the assembling substrate (200) onto a donor (300); and transferring the plurality of light emitting diodes (120, 130, 140) on the donor (300) onto an adhesive layer (116) of a display panel (PN).
14. The manufacturing method according to example 13, wherein the self-assembling of the plurality of light emitting diodes (120, 130, 140) comprises applying a voltage to a plurality of assembly electrodes (AE) on the assembling substrate (200) such that an electric field is formed and self-assembling the plurality of light emitting diodes (120, 130, 140) on the plurality of assembly electrodes (AE) with the electric field.
15. The manufacturing method according to example 13 or 14, wherein the assembling substrate (200) further includes: an assembly substrate (210); a plurality of first assembly lines (AL1) on the assembly substrate (210); a plurality of second assembly lines (AL2) on the assembly substrate (210) and are alternately disposed with the plurality of first assembly lines (AL1); an organic layer (OL) on the plurality of first assembly lines (AL1) and the plurality of second assembly lines (AL2) and includes a plurality of openings (OLH); and an assembly insulating layer (IL) on the organic layer (OL), and the plurality of assembly electrodes (AE) includes: a plurality of first assembly electrodes (AE1) that are electrically connected to the plurality of first assembly lines (AL1) ; and a plurality of second assembly electrodes (AE2) that are electrically connected to the plurality of second assembly lines (Al2) and face the plurality of first assembly electrodes (AE1)with a predetermined interval.

Although the exemplary embodiments of the present disclosure have been described in detail with reference to the accompanying drawings, the present disclosure is not limited thereto and may be embodied in many different forms without departing from the technical concept of the present disclosure. Therefore, the exemplary embodiments of the present disclosure are provided for illustrative purposes only but not intended to limit the technical concept of the present disclosure. The scope of the technical concept of the present disclosure is not limited thereto. Therefore, it should be understood that the above-described exemplary embodiments are illustrative in all aspects and do not limit the present disclosure.

## Claims

1. A display device, comprising:
a substrate (110 );
a thin film transistor (DT) over the substrate (110);
a reflective electrode (RE) over the thin film transistor (DT);
a first planarization layer (115) between the thin film transistor (DT) and the reflective electrode (RE);
an adhesive layer (116) on the reflective electrode (RE);
a light-emitting diode (120, 130, 140) on the adhesive layer (116) and connected to the thin film transistor (DT) via the reflective electrode (RE) and a first connection electrode (CE1), the light-emitting diode (120, 130, 140) comprising a first electrode (124, 134, 144) and a second electrode (125, 135, 145);
an encapsulation layer (126, 136, 146) over the light-emitting diode (120, 130, 140);
a second planarization layer (117) over the adhesive layer (116); and
a third planarization layer (118) over the encapsulation layer (126, 136, 146) and the second planarization layer (117) and a part of the third planarization layer (118) is between the first electrode (124, 134, 144) and the second electrode (125, 135, 145).

2. The display device according to claim 1, wherein the second planarization layer (117) and the third planarization layer (118) surround the light-emitting diode (120, 130, 140) and/or a thickness of the second planarization layer (117) is different from a thickness of the light-emitting diode (120, 130, 140) and/or an interface between the second planarization layer (117) and the third planarization layer (118) is in a different plane from a top surface of the light-emitting diode (120, 130, 140).

3. The display device according to claim 1 or 2, wherein a power line (VDD) between the thin film transistor (DT) and the first planarization layer (115);

4. The display device according to any one of the preceding claims, further comprising
a pixel including a plurality of sub pixels (SP) is defined on the substrate (110);
a plurality of light emitting diodes (120, 130, 140) being self-assembled and being transferred onto the adhesive layer (116) are disposed in the plurality of sub pixels (SP).

5. The display device according to claim 4, wherein the plurality of light emitting diodes (120, 130, 140) include a first light emitting diode (120), a second light emitting diode (130), and a third light emitting diode (140) having different planar shapes.

6. The display device according to claim 5, wherein the first light emitting diode (120) has a circular planar shape, and the first light emitting diode (120) includes:
a first n-type semiconductor layer (121) in contact with an upper surface of the adhesive layer (116);
a first light emitting layer (122) on the first n-type semiconductor layer (121);
a first p-type semiconductor layer (123) on the first light emitting layer (122);
a first n-type electrode (124) along a periphery of an upper surface of the first n-type semiconductor layer (121); and
a first p-type electrode (125) on an upper surface of the first p-type semiconductor layer (123) and having a circular planar shape.

7. The display device according to claim 5 or 6, wherein the second light emitting diode (130) has an elliptical planar shape, and the second light emitting diode (130) includes:
a second n-type semiconductor layer (131) in contact with an upper surface of the adhesive layer (116) and has an elliptical planar shape;
a second light emitting layer (132) on the second n-type semiconductor layer (131);
a second p-type semiconductor layer (133) on the second light emitting layer (132) and has an elliptical planar shape;
one pair of second n-type electrodes (134) adjacent to both end portions of the second n-type semiconductor layer (131) in a major axis direction of an upper surface of the second n-type semiconductor layer (131); and
a second p-type electrode (135) on an upper surface of the second p-type semiconductor layer (133) and having an elliptical planar shape, and
the major axis direction of the upper surface of the second n-type semiconductor layer (131) and a major axis direction of the upper surface of the second p-type semiconductor layer (133) are different.

8. The display device according to any one of the preceding claims 5, 6 or 7, wherein the third light emitting diode (140) has an elliptical planar shape having a different size from a planar shape of the second light emitting diode (130), the third light emitting diode (140) includes:
a third n-type semiconductor layer (141) in contact with the upper surface of the adhesive layer (116) and has an elliptical planar shape;
a third light emitting layer (142) on the third n-type semiconductor layer (141);
a third p-type semiconductor layer (143) on the third light emitting layer (142) and has an elliptical planar shape;
one pair of third n-type electrodes (144) adjacent to both end portions of the third n-type semiconductor layer (141) in a major axis direction of an upper surface of the third n-type semiconductor layer (141); and
a third p-type electrode (145) on an upper surface of the third p-type semiconductor layer (143) and having an elliptical planar shape, and
the major axis direction of the upper surface of the third n-type semiconductor layer (141) and a major axis direction of the upper surface of the third p-type semiconductor layer (143) are a same.

9. The display device according to any one of the preceding claims, wherein the plurality of light emitting diodes (120, 130, 140) are first self-assembled on an assembling substrate (200) in an arrangement corresponding to the plurality of sub pixels (SP) and then transferred onto the adhesive layer (116), preferably before being transferred onto the adhesive layer (116), the plurality of light emitting diodes (120, 130, 140) being self-assembled on the assembling substrate (200) are transferred onto a donor (300).

10. The display device according to claim 9, wherein the self-assembling of the plurality of light emitting diodes (120, 130, 140) is achieved by applying a voltage to a plurality of assembly electrodes (AE) on the assembling substrate (200) to form an electric field and self-assembling the plurality of light emitting diodes (120, 130, 140) on the plurality of assembly electrodes (AE) with the electric field.

11. The display device according to any one of the preceding claims, wherein a step coverage is between the adhesive layer (116) and the second planarization layer (117) and/or a step coverage is between the second planarization layer (117) and the third planarization layer (118) and/or the step coverage is in a contact hole through the adhesive layer (116), the second planarization layer (117), and the third planarization layer (118).

12. The display device according to any one of the preceding claims, further comprising a light shielding layer (LS) on the substrate (110), the thin film transistor (DT) comprises an active layer (ACT), and the light shielding layer (LS) overlaps at least one of the light-emitting diode (120, 130, 140), the active layer (ACT), or the reflective electrode (RE).

13. The display device according to any one of the preceding claims, wherein the first connection electrode (CE1) and a second connection electrode (CE2) are connected to the light-emitting diode (120, 130, 140) to thereby supply a signal via the first connection electrode (CE1) and the second to the light-emitting diode (120, 130, 140).

14. A manufacturing method of a display device, comprising:
self-assembling a plurality of light emitting diodes (120, 130, 140) as claimed in any one of the preceding claims on an assembling substrate (200);
transferring the plurality of light emitting diodes (120, 130, 140) which are self-assembled on the assembling substrate (200) onto a donor (300); and
transferring the plurality of light emitting diodes (120, 130, 140) on the donor (300) onto an adhesive layer (116) of a display panel (PN).

15. The manufacturing method according to claim 14, wherein the self-assembling of the plurality of light emitting diodes (120, 130, 140) comprises applying a voltage to a plurality of assembly electrodes (AE) on the assembling substrate (200) such that an electric field is formed and self-assembling the plurality of light emitting diodes (120, 130, 140) on the plurality of assembly electrodes (AE) with the electric field.
